# EUROPEAN PATENT APPLICATION

(11) **EP 4 550 973 A1**
(43) Date of publication of application: **07.05.2025**
(21) Application number: 24180096.0
(22) Date of filing: 05.06.2024
(51) Int. Cl.: H10D 30/01, H10D 30/00, H10D 62/10, H10D 30/43, H10D 64/01

(54) **SEMICONDUCTOR DEVICE**

(30) Priority: 01.11.2023 KR 20230148823
(71) Applicant: Samsung Electronics Co., Ltd., Suwon-si, Gyeonggi-do 16677 (KR)
(72) Inventor: YU, Hyun-Kwan, 16677 Suwon-si (KR); PARK, Hyun Woo, 16677 Suwon-si (KR); LEE, Sun Young, 16677 Suwon-si (KR)
(74) Representative: Marks & Clerk LLP

(57) **Abstract**

A semiconductor device is provided. The semiconductor device includes a substrate, an active pattern extending in a first horizontal direction (DR1) on the substrate, a plurality of nanosheets (NW1, NW2) stacked to be spaced apart from each other in a vertical direction (DR3) on the active pattern, a gate electrode (G) extending in a second horizontal direction (DR2) different from the first horizontal direction on the active pattern, the gate electrode surrounding the plurality of nanosheets, a source/drain region (SD) disposed on at least one side of the gate electrode on the active pattern, a first inner spacer (121) disposed between the source/drain region and the gate electrode between the plurality of nanosheets, the first inner spacer being in contact with the source/drain region, and a second inner spacer (122) disposed between the first inner spacer and the gate electrode between the plurality of nanosheets, the second inner spacer including a material different from a material of the first inner spacer, each of an upper surface (122u) and a lower surface (122b) of the second inner spacer being in contact with the first inner spacer.

## Description

### BACKGROUND

### 1. Technical Field

The present disclosure relates to a semiconductor memory device. Specifically, the present disclosure relates to a semiconductor device including a MBCFET^{™} (Multi-Bridge Channel Field Effect Transistor).

### 2. Description of the Related Art

As one of scaling technologies for increasing density of an integrated circuit device, a multi-gate transistor in which a silicon body having a fin shape or a nanowire shape is formed on a substrate and a gate is formed on a surface of the silicon body has been proposed.

Since such a multi-gate transistor utilizes a three-dimensional channel, scaling is easily performed. Further, even if a gate length of the multi-gate transistor is not increased, the current control capability may be improved. Furthermore, a SCE (short channel effect) in which potential of a channel region is influenced by a drain voltage may be effectively suppressed.

### SUMMARY

Aspects of the present disclosure provide a semiconductor device in which reliability is improved by forming an inner spacer including a double film including materials different from each other and effectively controlling a thickness of the inner spacer.

According to an embodiment of the present disclosure, a semiconductor device includes a substrate provided with an active pattern extending in a first horizontal direction parallel to an upper surface of the substrate, a plurality of nanosheets disposed on the active pattern and stacked to be spaced apart from each other in a vertical direction perpendicular to the upper surface of the substrate, a gate electrode disposed on the active pattern and extending in a second horizontal direction parallel to the upper surface of the substrate and different from the first horizontal direction, the gate electrode surrounding each of the plurality of nanosheets, a source/drain region disposed on the active pattern and disposed on a first side of the gate electrode, a first inner spacer disposed between the source/drain region and a first portion of the gate electrode disposed in a space between two adjacent nanosheets of the plurality of nanosheets, the first inner spacer contacting the source/drain region, and the first portion of the gate electrode being lower than an upper surface of the source/drain region, and a second inner spacer disposed between the first inner spacer and the first portion of the gate electrode, the second inner spacer including a material different from a material of the first inner spacer, and each of an upper surface and a lower surface of the second inner spacer contacting the first inner spacer.

According to an aspect of the present disclosure, a semiconductor device includes a substrate provided with an active pattern extending in a first horizontal direction parallel to an upper surface of the substrate, a plurality of nanosheets disposed on the active pattern and stacked to be spaced apart from each other in a vertical direction perpendicular to the upper surface of the substrate, a gate electrode disposed on the active pattern and extending in a second horizontal direction parallel to the upper surface of the substrate and different from the first horizontal direction, the gate electrode surrounding each of the plurality of nanosheets, a gate insulating layer disposed between a first portion of the gate electrode and each of two adjacent nanosheets of the plurality of nanosheets, wherein the first portion of the gate electrode is lower than the upper surface of the substrate, a source/drain region disposed on the active pattern and disposed on a first side of the gate electrode, a first inner spacer disposed in a space between the source/drain region and the gate insulating layer between the two adjacent nanosheets of the plurality of nanosheets, the first inner spacer including a first side wall contacting the source/drain region, and a second side wall contacting the gate insulating layer, and a second inner spacer disposed in a space between the first inner spacer and the gate insulating layer between the two adj acent nanosheets of the plurality of nanosheets, the second inner spacer including a material different from a material of the first inner spacer, the second inner spacer including a first side wall contacting the first inner spacer and a second side wall contacting the gate insulating layer, and the second inner spacer spaced apart from each of the plurality of nanosheets in the vertical direction.

According to an aspect of the present disclosure, a semiconductor device includes a substrate provided with an active pattern extending in a first horizontal direction parallel to an upper surface of the substrate, a plurality of nanosheets disposed on the active pattern and stacked to be spaced apart from each other in a vertical direction perpendicular to the upper surface of the substrate, a gate electrode disposed on the active pattern and extending in a second horizontal direction parallel to the upper surface of the substrate and different from the first horizontal direction, the gate electrode surrounding each of the plurality of nanosheets, a gate insulating layer disposed between a first portion of the gate electrode and each of two adjacent nanosheets of the plurality of nanosheets, a source/drain region disposed on the active pattern and disposed on a first side of the gate electrode, a first inner spacer disposed in a space between the source/drain region and the gate insulating layer between the two adjacent nanosheets of the plurality of nanosheets, the first inner spacer being in contact with each of the source/drain region and the gate insulating layer, and a second inner spacer disposed in a space between the first inner spacer and the gate insulating layer between the two adjacent nanosheets of the plurality of nanosheets, the second inner spacer including a material different from a material of the first inner spacer, a side wall of the second inner spacer being in contact with the gate insulating layer, and each of an upper surface and a lower surface of the second inner spacer being in contact with the first inner spacer. The second inner spacer is spaced apart from each of the plurality of nanosheets in the vertical direction. The second inner spacer is spaced apart from the source/drain region in the first horizontal direction. A side wall of the first inner spacer being in contact with the source/drain region is formed in a concave shape toward the gate electrode. The side wall of the second inner spacer being in contact with the gate insulating layer is formed in a concave shape toward the source/drain region.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

At least some of the above and other features of the invention are set out in the claims.

### BRIEF DESCRIPTION OF THE DRAWINGS

The above and other aspects and features of the present disclosure will become more apparent by describing in detail embodiments thereof, by way of example only, with reference to the attached drawings, in which:
FIG. 1 is a layout diagram for explaining a semiconductor device according to some embodiments of the present disclosure;
FIG. 2 is a cross-sectional view taken along line A-A' of FIG. 1;
FIG. 3 is an enlarged view of a region R1 of FIG. 2;
FIG. 4 is a cross-sectional view taken along line B-B' of FIG. 2;
FIGS. 5 to 27 are intermediate step diagrams for explaining a method of fabricating a semiconductor device according to some embodiments of the present disclosure;
FIG. 28 is a cross-sectional view for explaining a semiconductor device according to some embodiments of the present disclosure;
FIG. 29 is an enlarged view of a region R2 of FIG. 28;
FIG. 30 is a cross-sectional view for explaining a semiconductor device according to some embodiments of the present disclosure;
FIG. 31 is an enlarged view of a region R3 of FIG. 30;
FIG. 32 is a cross-sectional view for explaining a semiconductor device according to some embodiments of the present disclosure;
FIG. 33 is an enlarged view of a region R4 of FIG. 32;
FIGS. 34 and 36 are cross-sectional views for explaining a semiconductor device according to some embodiments of the present disclosure;
FIG. 35 is an enlarged view of a region R5 of FIG. 34;
FIG. 37 is a cross-sectional view for explaining a semiconductor device according to some embodiments of the present disclosure;
FIG. 38 is an enlarged view of a region R6 of FIG. 37;
FIG. 39 is a cross-sectional view for explaining a semiconductor device according to some embodiments of the present disclosure;
FIG. 40 is an enlarged view of a region R7 of FIG. 39;
FIG. 41 is a cross-sectional view for explaining a semiconductor device according to some embodiments of the present disclosure;
FIG. 42 is an enlarged view of a region R8 of FIG. 41;
FIG. 43 is a cross-sectional view for explaining a semiconductor device according to some embodiments of the present disclosure; and
FIG. 44 is an enlarged view of a region R9 of FIG. 43.

### DETAILED DESCRIPTION OF THE EMBODIMENTS

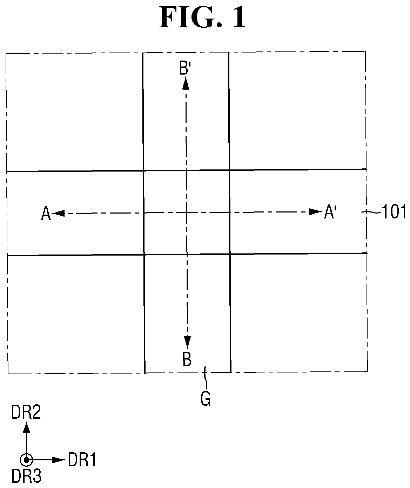

Hereinafter, a semiconductor device according to some embodiments of the present disclosure will be described with reference to FIGS. 1 to 4.

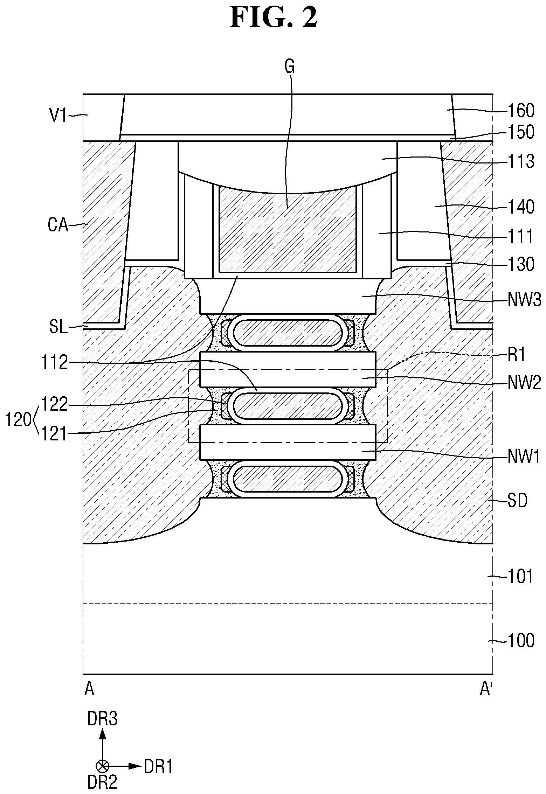

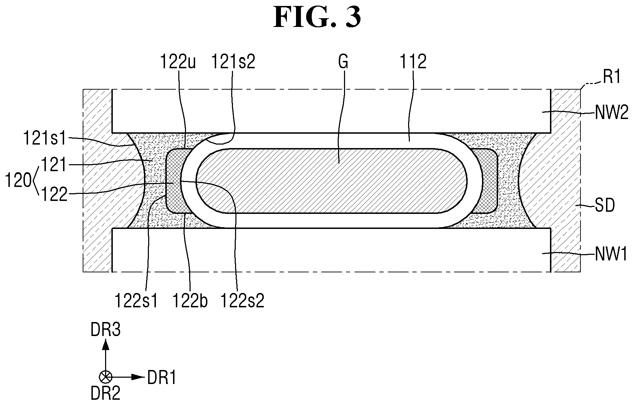

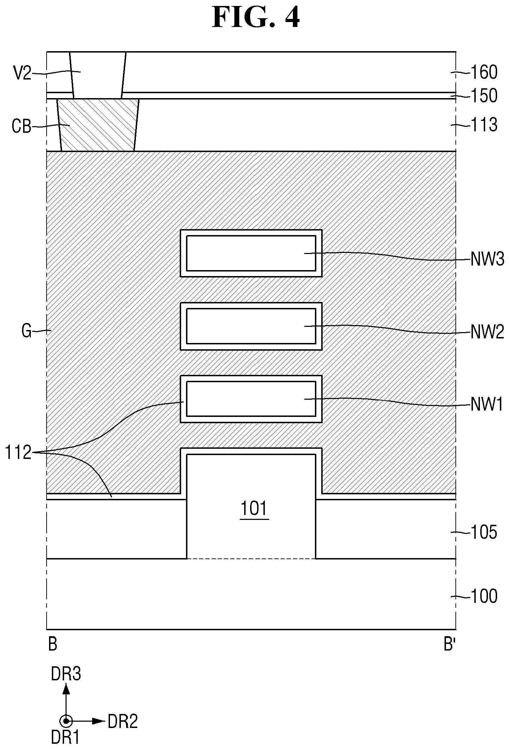

FIG. 1 is a layout diagram for explaining a semiconductor device according to some embodiments of the present disclosure. FIG. 2 is a cross-sectional view taken along line A-A' of FIG. 1. FIG. 3 is an enlarged view of a region R1 of FIG. 2. FIG. 4 is a cross-sectional view taken along line B-B' of FIG. 2.

Referring to FIGS. 1 to 4, the semiconductor device according to some embodiments of the present disclosure includes a substrate 100, an active pattern 101, a field insulating layer 105, a plurality of nanosheets NW1, NW2 and NW3, a gate electrode G, a gate spacer 111, a gate insulating layer 112, a capping pattern 113, a source/drain region SD, an inner spacer 120, a first etching stop layer 130, a first interlayer insulating layer 140, a source/drain contact CA, a silicide layer SL, a gate contact CB, a second etching stop layer 150, a second interlayer insulating layer 160, and first and second vias V1 and V2.

The substrate 100 may be a silicon substrate or silicon-on-insulator (SOI). In some embodiments, the substrate 100 may include or may be formed of silicon germanium, silicon germanium on insulator (SGOI), indium antimonide, lead telluride, indium arsenide, indium phosphide, gallium arsenide, or gallium antimonide, but the present disclosure is not limited thereto.

Hereinafter, each of a first horizontal direction DR1 and a second horizontal direction DR2 may be defined as a direction parallel to an upper surface of the substrate 100. The second horizontal direction DR2 may be defined as a direction different from the first horizontal direction DR1. In some embodiments, the second horizontal direction DR2 may be perpendicular to the first horizontal direction. A vertical direction DR3 may be defined as a direction perpendicular to each of the first horizontal direction DR1 and the second horizontal direction DR2. That is, the vertical direction DR3 may be defined as a direction perpendicular to the upper surface of the substrate 100.

The substrate 100 may be provided with the active pattern 101 that extends on the substrate 100 in the first horizontal direction DR1. The active pattern 101 may protrude from the upper surface of the substrate 100 in the vertical direction DR3. In some embodiments, the active pattern 101 may be a part of substrate 100. The active pattern 101 may be formed by patterning the substrate 100. In some embodiments, the active pattern 101 may include an epitaxial layer grown from the substrate 100.

The field insulating layer 105 may be disposed on the upper surface of the substrate 100. The field insulating layer 105 may surround side walls of the active pattern 101. For example, the upper surface of the active pattern 101 may protrude beyond the upper surface of the field insulating layer 105 in the vertical direction DR3. However, the present disclosure is not limited thereto. In some embodiments, the upper surface of the active pattern 101 may be formed on the same plane as the upper surface of the field insulating layer 105. The field insulating layer 105 may include or may be formed of, for example, an oxide film, a nitride film, an oxynitride film or a combined film thereof.

A plurality of nanosheets NW1, NW2, and NW3 may be disposed on the active pattern 101. The plurality of nanosheets NW1, NW2, and NW3 may be stacked on the active pattern 101 to be spaced apart from each other in the vertical direction DR3. For example, the plurality of nanosheets NW1, NW2, and NW3 may include a first nanosheet NW1, a second nanosheet NW2, and a third nanosheet NW3. The first nanosheet NW1 may be spaced apart from the active pattern 101 in the vertical direction DR3 on the active pattern 101. The second nanosheet NW2 may be spaced apart from the first nanosheet NW1 in the vertical direction DR3 on the first nanosheet NW1. The third nanosheet NW3 may be spaced apart from the second nanosheet NW2 in the vertical direction DR3 on the second nanosheet NW2.

Although the plurality of nanosheets NW1, NW2, and NW3 are shown in FIGS. 2 and 4 as including three nanosheets stacked to be spaced apart from each other in the vertical direction DR3, this is for convenience of explanation, and the present disclosure is not limited thereto. In some embodiments, the plurality of nanosheets may include four or more nanosheets stacked to be spaced apart from each other in the vertical direction DR3. In some embodiments, each of the first to third nanosheets NW1, NW2, and NW3 may include or may be formed of silicon (Si). However, the present disclosure is not limited thereto. In some embodiments, each of the first to third nanosheets NW1, NW2, and NW3 may include or may be formed of silicon germanium (SiGe).

The gate electrode G may extend in the second horizontal direction DR2 on the active pattern 101 and the field insulating layer 105. The gate electrode G may surround each of the plurality of nanosheets NW1, NW2, and NW3. The gate electrode G may include or may be formed of, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and a combination thereof. The gate electrode G may include a conductive metal oxide, a conductive metal oxynitride or the like, and may include an oxidized form of the aforementioned materials.

The gate spacer 111 may extend in the second horizontal direction DR2 along opposite side walls of the gate electrode G on the upper surface of the uppermost nanosheet of the plurality of nanosheets NW1, NW2, and NW3 and on the field insulating layer 105. For example, the gate spacer 111 may extend in the second horizontal direction DR2 along opposite side walls of the gate electrode G on the upper surface of the third nanosheet NW3 and the field insulating layer 105. The gate spacer 111 may include or may be formed of, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and a combination thereof. However, the present disclosure is not limited thereto.

The source/drain region SD may be disposed on at least one side of the gate electrode G on the active pattern 101. For example, the source/drain regions SD may be disposed on opposite sides of the gate electrode G on the active pattern 101. The source/drain regions SD may be in contact with opposite side walls of each of the plurality of nanosheets NW1, NW2, and NW3 in the first horizontal direction DR1. For example, the upper surface of the source/drain region SD may be formed to be higher than the upper surface of the third nanosheet NW3. The term "contact," as used herein, refers to a direct connection (i.e., physical touching) unless the context indicates otherwise.

The gate insulating layer 112 may be disposed between the gate electrode G and the gate spacer 111. The gate insulating layer 112 may be disposed between the gate electrode G and the active pattern 101. The gate insulating layer 112 may be disposed between the gate electrode G and the field insulating layer 105. The gate insulating layer 112 may be disposed between the gate electrode G and each of the plurality of nanosheets NW1, NW2, and NW3. The gate insulating layer 112 may be disposed between the gate electrode G and the source/drain region SD. The gate insulating layer 112 may be in contact with each of the gate electrode G, the plurality of nanosheets NW1, NW2, and NW3, the active pattern 101, and the field insulating layer 105.

The gate insulating layer 112 may include or may be formed of at least one of silicon oxide, silicon oxynitride, silicon nitride, and a high dielectric constant material having a higher dielectric constant than silicon oxide. The high dielectric constant material may include, for example, one or more of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate.

The semiconductor device according to some embodiments may include an NC (Negative Capacitance) FET that uses a negative capacitor. For example, the gate insulating layer 112 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitances decrease from (i.e., are smaller than) the capacitance of each of the individual capacitors. On the other hand, if at least one of the capacitances of two or more capacitors connected in series has a negative value, the overall capacitances may be greater than an absolute value of each of the individual capacitances, while having a positive value.

When the ferroelectric material film having the negative capacitance and the paraelectric material film having the positive capacitance are connected with each other in series, the overall capacitance values of the ferroelectric material film and the paraelectric material film connected in series may increase. The increased overall capacitance value may allow a transistor including the ferroelectric material film to have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, and lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of dopant included in the ferroelectric material film may vary, depending on which type of ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have the paraelectric properties. The paraelectric material film may include at least one of, for example, silicon oxide and a metal oxide having a high dielectric constant. The metal oxide included in the paraelectric material film may include, for example, but not limited to, at least one of hafnium oxide, zirconium oxide, and aluminum oxide.

The ferroelectric material film and the paraelectric material film may include or may be formed of the same material. The ferroelectric material film has the ferroelectric properties, but the paraelectric material film may not have the ferroelectric properties. For example, when the ferroelectric material film and the paraelectric material film include hafnium oxide, a crystal structure of hafnium oxide included in the ferroelectric material film is different from a crystal structure of hafnium oxide included in the paraelectric material film.

The ferroelectric material film may have a thickness having the ferroelectric properties. The thickness of the ferroelectric material film may be, for example, but not limited to, 0.5 to 10 nm. Since a critical thickness at which the ferroelectric material film exhibits the ferroelectric properties may vary for each ferroelectric material, the thickness of the ferroelectric material film may vary depending on the ferroelectric material. As an example, the gate insulating layer 112 may include one ferroelectric material film. As another example, the gate insulating layer 112 may include a plurality of ferroelectric material films spaced apart from each other. The gate insulating layer 112 may have a stacked film structure in which a plurality of ferroelectric material films and a plurality of paraelectric material films are alternately stacked.

The inner spacer 120 may be disposed between the source/drain region SD and the gate electrode G, between two adjacent nanosheets among the plurality of nanosheets NW1, NW2, and NW3. Specifically, the inner spacer 120 may be disposed between the source/drain region SD and the gate insulating layer 112, between two adjacent nanosheets among the plurality of nanosheets NW1, NW2, and NW3. The inner spacer 120 may also be disposed between the source/drain region SD and the gate electrode G, between the active pattern 101 and the first nanosheet NW1. Specifically, the inner spacer 120 may be disposed between the source/drain region SD and the gate insulating layer 112, between the active pattern 101 and the first nanosheet NW1. In some embodiments, the inner spacer 120 may be disposed in a first space between two adjacent nanosheets NW1 and NW2 in the vertical direction DR3, and may be disposed in a space between a first portion of the gate electrode G and a first portion of the source/drain region SD in the first horizontal direction DR1. The first portion of the gate electrode G and the first portion of the source/drain region SD may be disposed in the space between two adjacent nanosheets NW1 and NW2. The inner spacer 120 may also be disposed in a second space between the first nanosheet NW1 and the active pattern 101, and in a third space between the second nanosheet NW2 and a third nanosheet NW3. For example, the inner spacer 120 may be disposed in each of the first space between two adjacent nanosheets NW1 and NW2, the second space between the first nanosheet NW1 and the active pattern 101, and third space between the second nanosheet NW2 and the third nanosheet NW3.

The inner spacer 120 may be in contact with the source/drain region SD and the gate insulating layer 112 between two adjacent nanosheets among the plurality of nanosheets NW1, NW2, and NW3. The inner spacer 120 may also be in contact with each of the source/drain region SD and the gate insulating layer 112 between the active pattern 101 and the first nanosheet NW1. The inner spacer 120 may include a first inner spacer 121 and a second inner spacer 122.

The first inner spacer 121 may be disposed between the source/drain region SD and the gate insulating layer 112, between two adjacent nanosheets among the plurality of nanosheets NW1, NW2, and NW3. The first inner spacer 121 may also be disposed between the source/drain region SD and the gate insulating layer 112, and between the active pattern 101 and the first nanosheet NW1. The first inner spacer 121 may be in contact with each of the plurality of nanosheets NW1, NW2, and NW3 and may be disposed between two adjacent nanosheets among the plurality of nanosheets NW1, NW2, and NW3. The first inner spacer 121 may be in contact with the active pattern 101 between the active pattern 101 and the first nanosheet NW1.

The first inner spacer 121 may include a first side wall 121s1, and a second side wall 121s2 opposite to the first side wall 121s1 in the first horizontal direction DR1. The first side wall 121s1 of the first inner spacer 121 may be in contact with the source/drain region SD. For example, the first side wall 121s1 of the first inner spacer 121 may be formed in a concave shape toward the gate electrode G (i.e., a portion of the gate electrode G disposed in a space between two adjacent nanosheets among the plurality of nanosheets NW1, NW2, and NW3). For example, the side wall of the source/drain region SD that is in contact with the first side wall 121s1 of the first inner spacer 121 may be formed to be closer to the gate electrode G than the side walls in the first horizontal direction DR1 of each of the plurality of nanosheets NW1, NW2, and NW3.

The second side wall 121s2 of the first inner spacer 121 may be in contact with the gate insulating layer 112. For example, at least a part of the second side wall 121s2 of the first inner spacer 121 may overlap the gate electrode G in the vertical direction DR3. That is, at least a part of the first inner spacer 121 may overlap the gate electrode G in the vertical direction DR3. The first inner spacer 121 may include a low dielectric constant material. For example, the first inner spacer 121 may include or may be formed of silicon oxide (SiO₂).

The second inner spacer 122 may be disposed between the first inner spacer 121 and the gate insulating layer 112, between two adjacent nanosheets among the plurality of nanosheets NW1, NW2, and NW3. The second inner spacer 122 may also be disposed between the first inner spacer 121 and the gate insulating layer 112, and between the active pattern 101 and the first nanosheet NW1. The second inner spacer 122 may be spaced apart from the source/drain region SD in the first horizontal direction DR1. That is, the second inner spacer 122 may not be in contact with the source/drain region SD.

The second inner spacer 122 may be spaced apart from each of the plurality of nanosheets NW1, NW2, and NW3 in the vertical direction DR3 and may be disposed between two adjacent nanosheets among the plurality of nanosheets NW1, NW2, and NW3. The second inner spacer 122 may also be spaced apart from each of the active pattern 101 and the first nanosheet NW1 in the vertical direction DR3 and disposed between the active pattern 101 and the first nanosheet NW1. That is, the second inner spacer 122 may not be in contact with each of the active pattern 101 and each of the plurality of nanosheets NW1, NW2, and NW3.

The second inner spacer 122 may be in contact with each of the first inner spacer 121 and the gate insulating layer 112. For example, the second inner spacer 122 may include a first side wall 122s 1, and a second side wall 122s2 opposite to the first side wall 122s 1 in the first horizontal direction DR1. The first side wall 122s1 of the second inner spacer 122 may be in contact with the first inner spacer 121. The second side wall 122s2 of the second inner spacer 122 may be in contact with the gate insulating layer 112. For example, the second side wall 122s2 of the second inner spacer 122 may be formed in a concave shape toward the source/drain region SD (i.e., a portion of the source/drain region SD disposed between two adjacent nanosheets among the plurality of nanosheets NW1, NW2, and NW3).

Each of an upper surface 122u and a lower surface 122b of the second inner spacer 122 may be in contact with the first inner spacer 121. That is, the first inner spacer 121 may be disposed between the second inner spacer 122 and each of the plurality of nanosheets NW1, NW2, and NW3. Further, the first inner spacer 121 may be disposed between the second inner spacer 122 and the active pattern 101.

The second inner spacer 122 may include or may be formed of a low dielectric constant material. The second inner spacer 122 may include or may be formed of a material having etching selectivity against the first inner spacer 121. That is, the second inner spacer 122 may include or may be formed of a different material from the first inner spacer 121. For example, the second inner spacer 122 may include or may be formed of silicon nitride (SiN). In some embodiments, the second inner spacer 122 may include or may be formed of any one of silicon oxyoxycarbide (SiOC), silicon oxynitride (SiON), silicon oxycarbonitride (SiOCN), and silicon carbonitride (SiCN).

The first etching stop layer 130 may be disposed on a side wall of the gate spacer 111 in the first horizontal direction DR1. Although not shown, the first etching stop layer 130 may be disposed on the upper surface of the field insulating layer 105 in a region in which the gate spacer 111 is not disposed. The first etching stop layer 130 may be disposed on the surface of the source/drain region SD. For example, the first etching stop layer 130 may be formed conformally. The first etching stop layer 130 may include or may be formed of, for example, at least one of aluminum oxide, aluminum nitride, hafnium oxide, zirconium oxide, silicon oxide, silicon nitride, silicon oxynitride, and a low dielectric constant material.

The capping pattern 113 may extend in the second horizontal direction DR2 on each of the gate spacer 111, the gate insulating layer 112, the gate electrode G, and the first etching stop layer 130. For example, a lower surface of the capping pattern 113 may be in contact with the first etching stop layer 130. However, the present disclosure is not limited thereto. In some embodiments, the side walls of the capping pattern 113 may be in contact with the first etching stop layer 130. The capping pattern 113 may include or may be formed of, for example, at least one of silicon nitride (SiN), silicon oxynitride (SiON), silicon oxide (SiO₂), silicon carbonitride (SiCN), silicon oxycarbonitride (SiOCN), and a combination thereof. However, the present disclosure is not limited thereto.

The first interlayer insulating layer 140 may be disposed on the first etching stop layer 130. The first interlayer insulating layer 140 may surround the side walls of the capping pattern 113. For example, the upper surface of the first interlayer insulating layer 140 may be formed on the same plane as the upper surface of the capping pattern 113. The first interlayer insulating layer 140 may include or may be formed of, for example, at least one of silicon oxide, silicon nitride, silicon oxynitride, and a low dielectric constant material. The low dielectric constant material may include, for example, at least one of Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSililPhosphate (TMSP), PolyTetraFluoroEthylene (PTFE), TOSZ (Tonen SilaZen), FSG (Fluoride Silicate Glass), polyimide nanofoams such as polypropylene oxide, CDO (Carbon Doped silicon Oxide), OSG (Organo Silicate Glass), SiLK, Amorphous Fluorinated Carbon, silica aerogels, silica xerogels, mesoporous silica, and a combination thereof. However, the present disclosure is not limited thereto.

The source/drain contact CA may penetrate the first interlayer insulating layer 140 and the first etching stop layer 130 in the vertical direction DR3, and may be connected to the source/drain region SD. The source/drain contact CA may be electrically connected to the source/drain region SD. For example, the upper surface of the source/drain contact CA may be formed on the same plane as the upper surface of the first interlayer insulating layer 140, but the present disclosure is not limited thereto. Although the source/drain contact CA is shown as being formed of a single film in FIG. 2, the present disclosure is not limited thereto. In some embodiments, the source/drain contact CA may be formed of multiple films.

The source/drain contact CA may include or may be formed of, for example, at least one of tantalum (Ta), tantalum nitride (TaN), titanium (Ti), titanium nitride (TiN), ruthenium (Ru), cobalt (Co), nickel (Ni), nickel boron (NiB), tungsten (W), tungsten nitride (WN), zirconium (Zr), zirconium nitride (ZrN), vanadium (V), vanadium nitride (VN), niobium (Nb), niobium nitride (NbN), platinum (Pt), iridium (Ir), rhodium (Rh), aluminum (Al), copper (Cu), and molybdenum (Mo). A silicide layer SL may be disposed between the source/drain contact CA and the source/drain region SD. The silicide layer SL may include or may be formed of, for example, a metal silicide material.

The gate contact CB may penetrate the capping pattern 113 in the vertical direction DR3 and be connected to the gate electrode G. For example, the upper surface of the gate contact CB may be formed on the same plane as the upper surface of the first interlayer insulating layer 140, but the present disclosure is not limited thereto. Although the gate contact CB is shown as being formed of a single film in FIG. 4, the present disclosure is not limited thereto. In some embodiments, the gate contact CB may be formed of multiple films.

The gate contact CB may include or may be formed of, for example, at least one of tantalum (Ta), tantalum nitride (TaN), titanium (Ti), titanium nitride (TiN), ruthenium (Ru), cobalt (Co), nickel (Ni), nickel boron (NiB), tungsten (W), tungsten nitride (WN), zirconium (Zr), zirconium nitride (ZrN), vanadium (V), vanadium nitride (VN), niobium (Nb), niobium nitride (NbN), platinum (Pt), iridium (Ir), rhodium (Rh), aluminum (Al), copper (Cu), and molybdenum (Mo).

The second etching stop layer 150 may be disposed on each of the first interlayer insulating layer 140, the capping pattern 113, the source/drain contact CA, and the gate contact CB. Although the second etching stop layer 150 is shown as being formed of a single film in FIGS. 2 and 4, the present disclosure is not limited thereto. In some embodiments, the second etching stop layer 150 may be formed of multiple films. The second etching stop layer 150 may include or may be formed of, for example, at least one of aluminum oxide, aluminum nitride, hafnium oxide, zirconium oxide, silicon oxide, silicon nitride, silicon oxynitride, and a low dielectric constant material. The second interlayer insulating layer 160 may be disposed on the second etching stop layer 150. The second interlayer insulating layer 160 may include, for example, at least one of silicon oxide, silicon nitride, silicon oxynitride, and a low dielectric constant material.

A first via V1 penetrates the second interlayer insulating layer 160 and the second etching stop layer 150 in the vertical direction DR3, and may be connected to the source/drain contact CA. A second via V2 penetrates the second interlayer insulating layer 160 and the second etching stop layer 150 in the vertical direction DR3, and may be connected to the gate contact CB. Although each of the first via V1 and the second via V2 is shown as being formed of a single film in FIGS. 2 and 4, the present disclosure is not limited thereto. In some embodiments, each of the first via V1 and the second via V2 may be formed of multiple films. Each of the first via V1 and the second via V2 may include or may be formed of a conductive material.

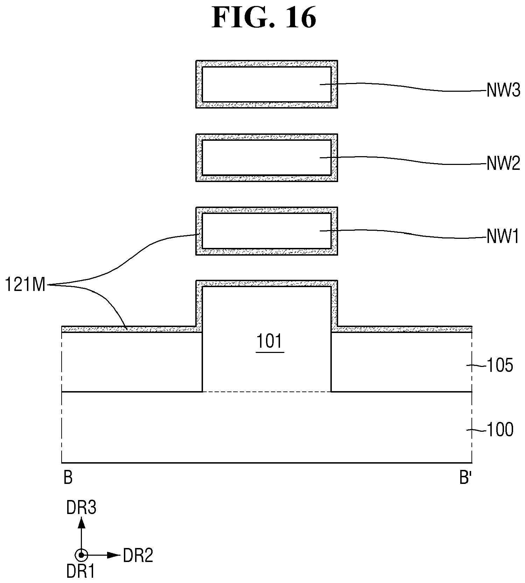

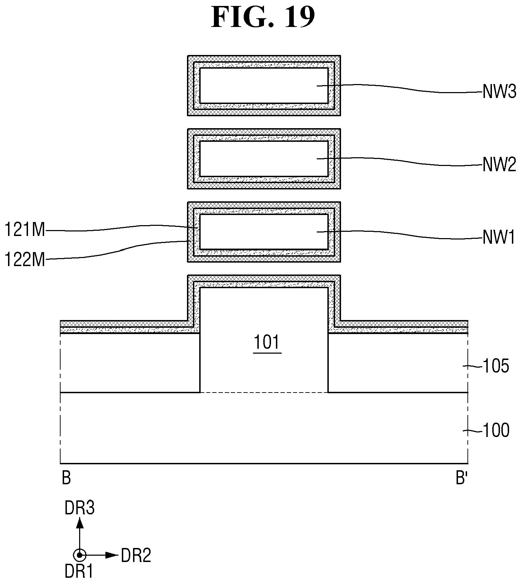

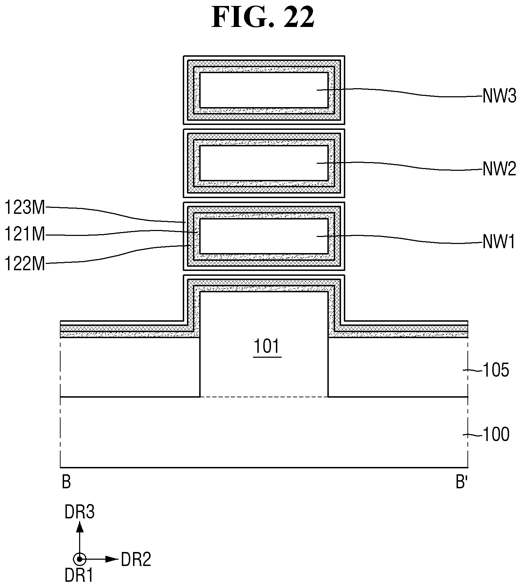

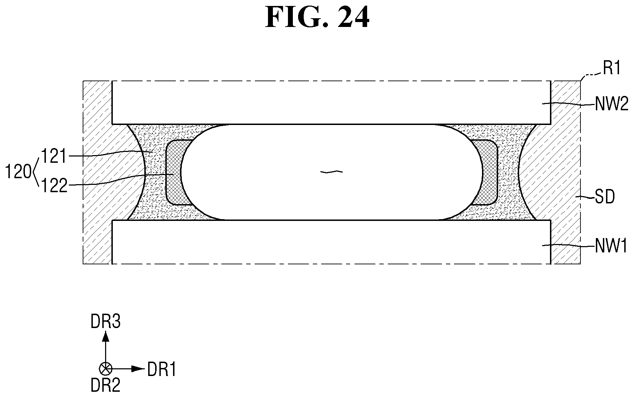

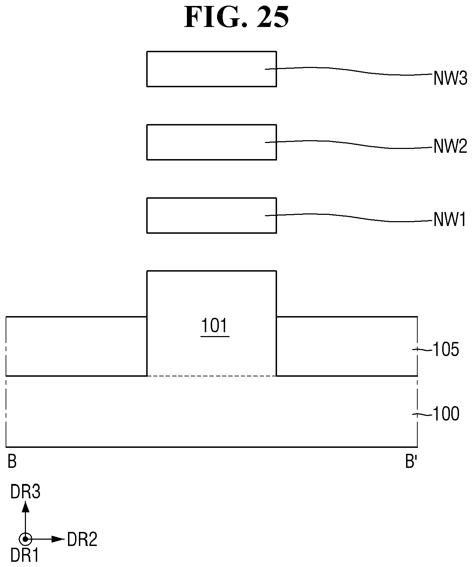

Hereinafter, a method of fabricating the semiconductor device according to some embodiments of the present disclosure will be described with reference to FIGS. 2 to 27.

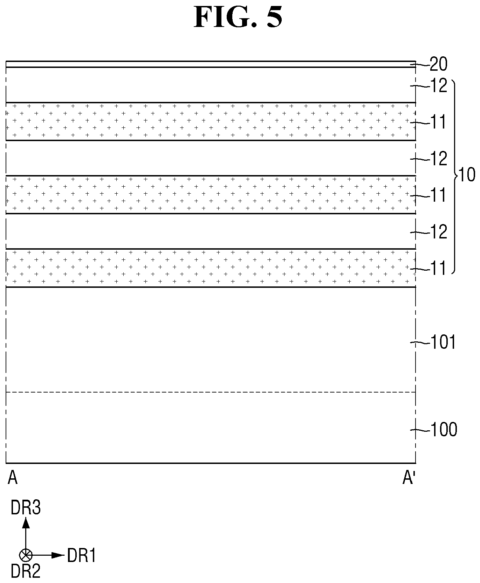

FIGS. 5 to 27 are intermediate step diagrams for explaining the method of fabricating the semiconductor device according to some embodiments of the present disclosure.

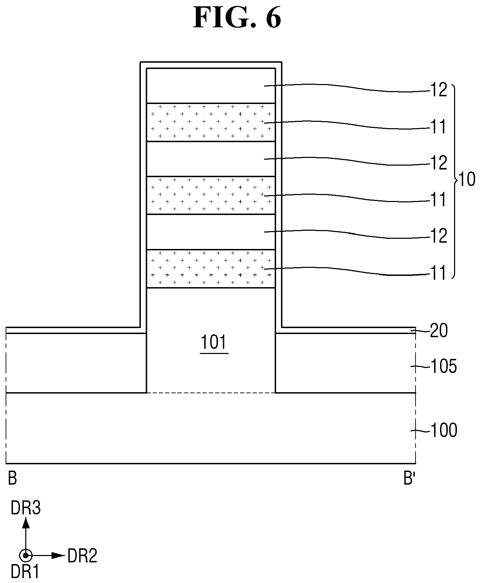

Referring to FIGS. 5 and 6, a stacked structure 10 may be formed on the substrate 100. The stacked structure 10 may include a sacrificial layer 11 and a semiconductor layer 12 that are alternately stacked on the substrate 100. For example, the sacrificial layer 11 may be formed at the bottom of the stacked structure 10, and the semiconductor layer 12 may be formed at the top of the stacked structure 10. However, the present disclosure is not limited thereto. In some embodiments, the sacrificial layer 11 may also be formed on the top of the stacked structure 10. The sacrificial layer 11 may include or may be formed of, for example, silicon germanium (SiGe). The semiconductor layer 12 may include or may be formed of, for example, silicon (Si).

A part of the stacked structure 10 may then be etched. A part of the substrate 100 may also be etched, while the stacked structure 10 is being etched. Through such an etching process, the active pattern 101 may be defined below the stacked structure 10 on the upper surface of the substrate 100. The active pattern 101 may extend in the first horizontal direction DR1. Subsequently, the field insulating layer 105 may be formed on the upper surface of the substrate 100. The field insulating layer 105 may surround side walls of the active pattern 101. For example, the upper surface of the active pattern 101 may be formed to be higher than the upper surface of the field insulating layer 105.

Subsequently, a pad oxide layer 20 may be formed to cover the upper surface of the field insulating layer 105, the exposed side walls of the active pattern 101, and the side walls and upper surface of the stacked structure 10. For example, the pad oxide layer 20 may be formed conformally. The pad oxide layer 20 may include or may be formed of, for example, silicon oxide (SiO₂).

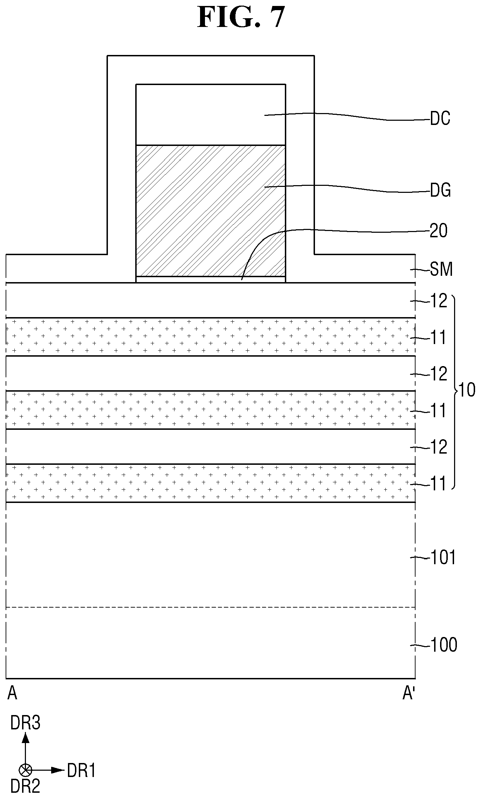

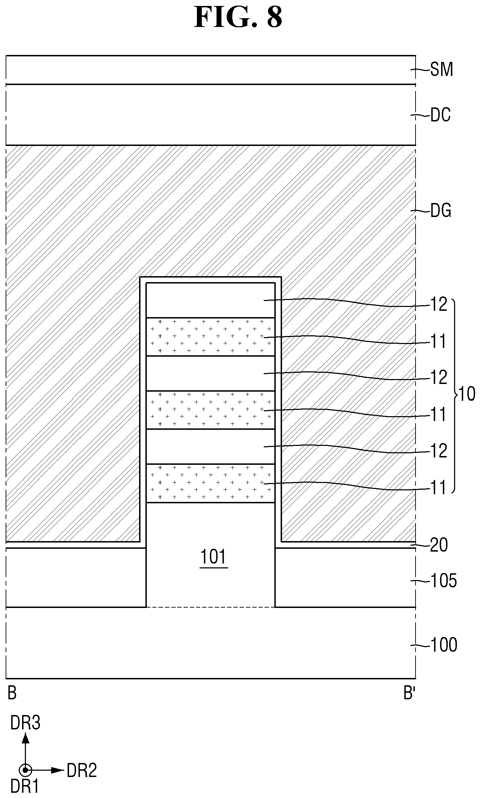

Referring to FIGS. 7 and 8, a dummy gate DG and a dummy capping pattern DC extending in the second horizontal direction DR2 on the pad oxide layer 20 may be formed on the stacked structure 10 and the field insulating layer 105. The dummy capping pattern DC may be disposed on the dummy gate DG. While the dummy gate DG and the dummy capping pattern DC are being formed, the remaining pad oxide layer 20 except for the portion that overlaps the dummy gate DG in the vertical direction DR3 on the substrate 100 may be removed.

Next, a spacer material layer SM may be formed to cover the side walls of the dummy gate DG, the side walls and upper surface of the dummy capping patterns DC, the side walls and upper surface of the exposed stacked structure 10, and the upper surface of the field insulating layer 105. For example, the spacer material layer SM may be formed conformally. The spacer material layer SM may include or may be formed of, for example, at least one of silicon nitride (SiN), silicon oxycarbonitride (SiOCN), silicon boron carbonitride (SiBCN), silicon carbonitride (SiCN), silicon oxynitride (SiON), and a combination thereof.

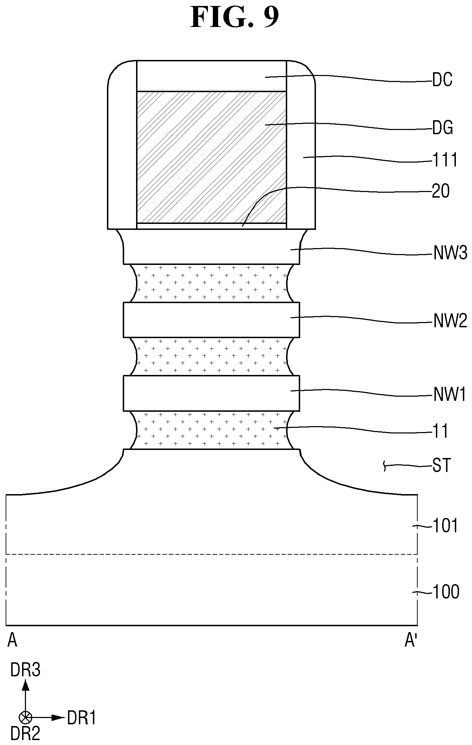

Referring to FIG. 9, the stacked structure 10 of FIG. 7 may be etched using the dummy gate DG and the dummy capping pattern DC as a mask to form a source/drain trench ST. For example, the source/drain trench ST may extend into the active pattern 101. During the formation of the source/drain trench ST, a part of each of the spacer material layer SM of FIG. 7 formed on the upper surface of the dummy capping pattern DC and the dummy capping pattern DC may be etched. Furthermore, during the formation of the source/drain trenches ST, a part of opposite side walls of the sacrificial layer 11 in the first horizontal direction DR1 may be etched. Therefore, opposite side walls of the sacrificial layer 11 in the first horizontal direction DR1 may be formed to be recessed toward the center of the sacrificial layer 11.

For example, the spacer material layer SM of FIG. 7 remaining on the side walls of each of the dummy capping pattern DC and the dummy gate DG may be defined as a gate spacer 111. For example, after the source/drain trench ST is formed, each of the semiconductor layers 12 of FIG. 7 remaining below the dummy gate DG on the active pattern 101 may be defined as first to third nanosheets NW1, NW2, and NW3.

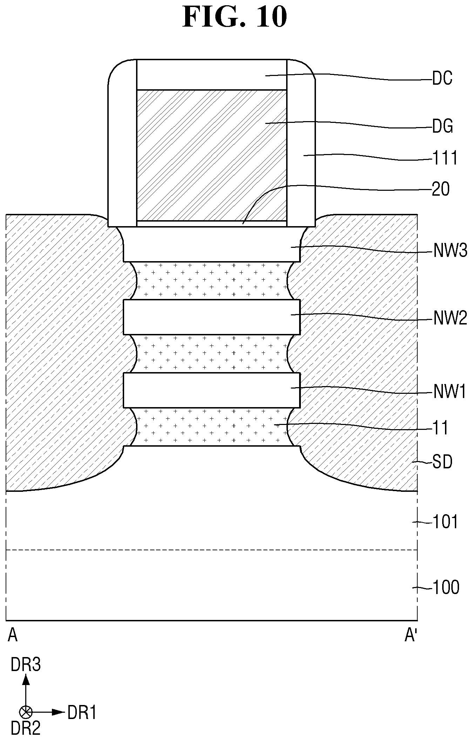

Referring to FIG. 10, the source/drain region SD may be formed inside the source/drain trenches ST of FIG. 9. For example, the source/drain region SD may be in contact with the side walls in the first horizontal direction DR1 of each of the first to third nanosheets NW1, NW2, and NW3. Further, the source/drain region SD may be in contact with the side wall of the sacrificial layer 11 in the first horizontal direction DR1. For example, the source/drain region SD may include a first source/drain region and a second source/drain region that are spaced apart from each other in the first horizontal direction DR1, and that are disposed on opposite side walls of the sacrificial layer 11, respectively.

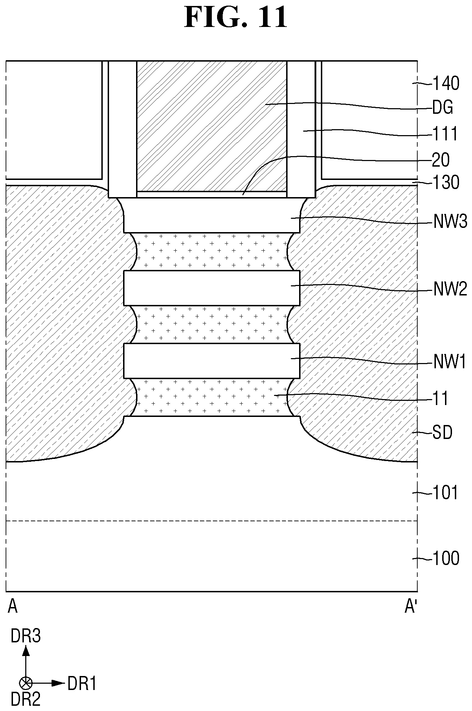

Referring to FIG. 11, the first etching stop layer 130 may be formed on the surface of the source/drain region SD and the side walls of the gate spacer 111. Although it is not shown, the first etching stop layer 130 may also be formed on the upper surface of the field insulating layer 105. For example, the first etching stop layer 130 may be formed conformally. Subsequently, a first interlayer insulating layer 140 may be formed on the first etching stop layer 130. Next, the upper surface of the dummy gate DG may be exposed through a planarization process.

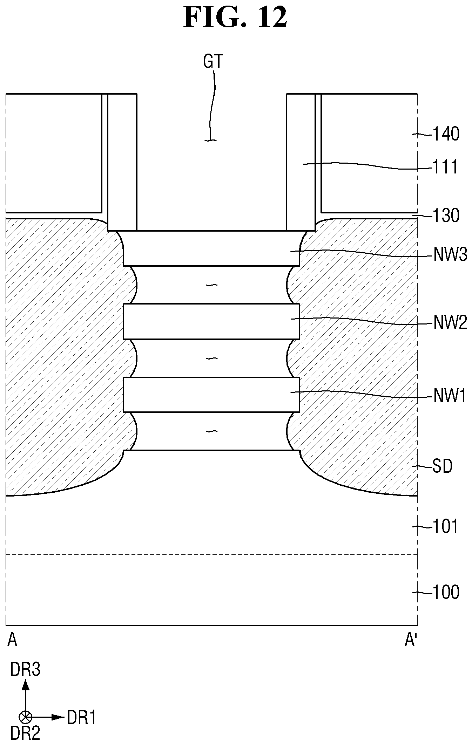

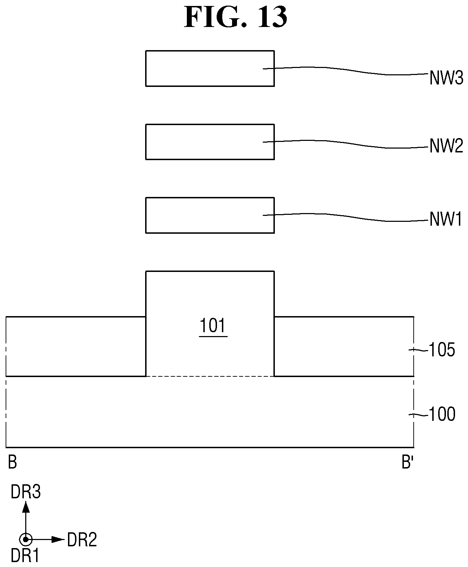

Referring to FIGS. 12 and 13, each of the dummy gate DG of FIG. 11, the pad oxide layer 20 of FIG. 11, and the sacrificial layer 11 of FIG. 11 may be etched. The removed portions of the dummy gate DG of FIG. 11, the pad oxide layer 20 of FIG. 11, and the sacrificial layer 11 of FIG. 11 may be collectively defined as a gate trench GT.

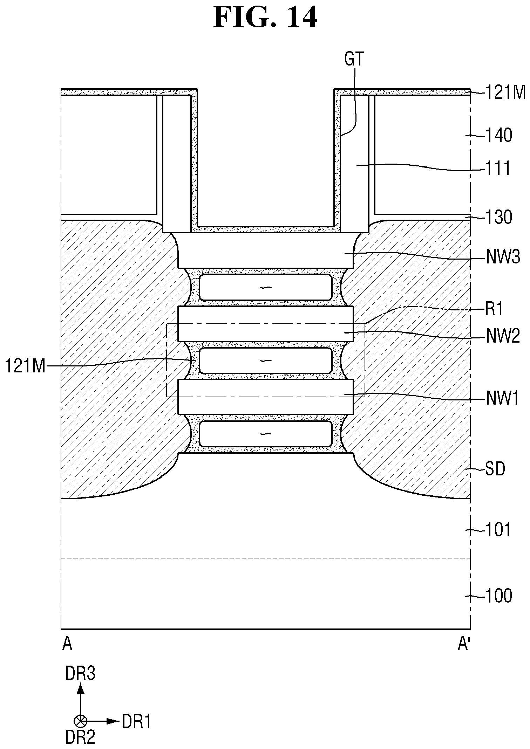

Referring to FIGS. 14 to 16, a first inner spacer material layer 121M may be conformally formed inside the gate trench GT. For example, the first inner spacer material layer 121M may be formed into a liner shape. For example, the first inner spacer material layer 121M may be formed on the surface of the source/drain region SD exposed to the inside of the gate trench GT. The first inner spacer material layer 121M may be formed on the surface of the field insulating layer 105, the surface of the active pattern 101, and surfaces of each of the first to third nanosheets NW 1, NW2, and NW3 exposed to the inside of the gate trench GT. The first inner spacer material layer 121M may be formed on the side wall of the gate spacer 111 exposed to the inside of the gate trench GT. Also, the first inner spacer material layer 121M may be formed on the upper surface of the gate spacer 111 and the upper surface of the first interlayer insulating layer 140.

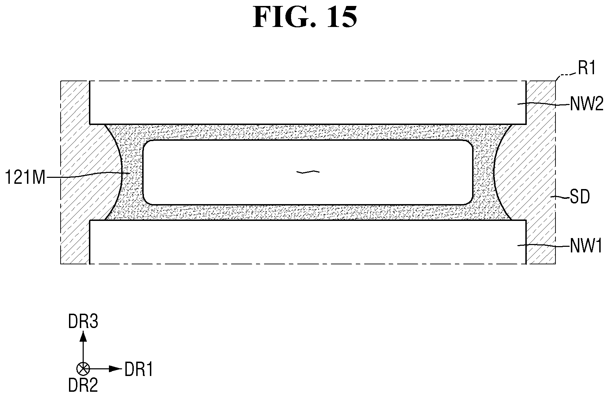

For example, as shown in FIGS. 14 and 15, in a cross section taken along the first horizontal direction DR1, a thickness in the first horizontal direction DR1 of the first inner spacer material layer 121M formed on the side wall of the source/drain region SD may be greater than a thickness in the vertical direction DR3 of the first inner spacer material layer 121M formed on each of the upper surface of the active pattern 101, and the upper surfaces or lower surfaces of each of the first to third nanosheets NW1, NW2, and NW3. The first inner spacer material layer 121M may include or may be formed of a low dielectric constant material. For example, the first inner spacer material layer 121M may include or may be formed of silicon oxide (SiO₂).

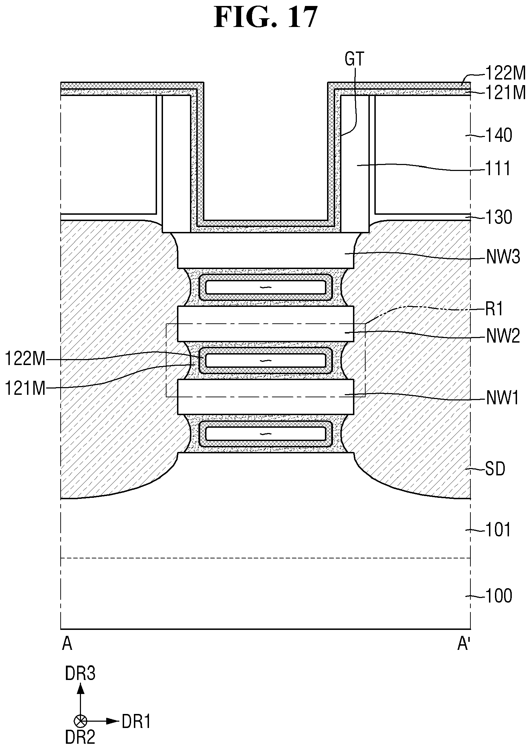

Referring to FIGS. 17 to 19, a second inner spacer material layer 122M may be conformally formed on the first inner spacer material layer 121M. The second inner spacer material layer 122M may be formed into a liner shape. For example, the second inner spacer material layer 122M may be formed on the first inner spacer material layer 121M inside the gate trench GT. For example, the second inner spacer material layer 122M may be formed on the first inner spacer material layer 121M, on the upper surface of the gate spacer 111 and the upper surface of the first interlayer insulating layer 140.

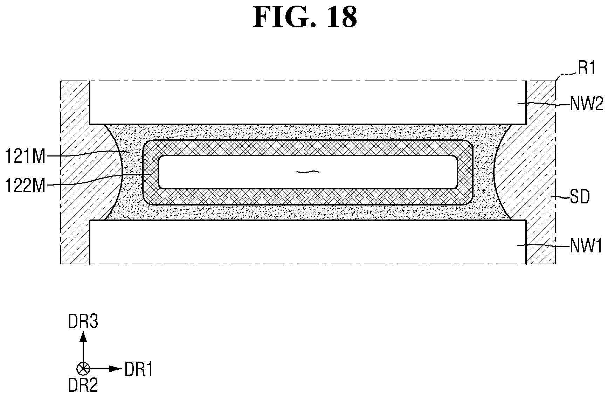

For example, as shown in FIGS. 17 and 18, in a cross section taken along the first horizontal direction DR1, a thickness in the first horizontal direction DR1 of the second inner spacer material layer 122M formed on the side wall of the source/drain region SD may be greater than a thickness in the vertical direction DR3 of the second inner spacer material layer 122M formed on the upper surface of the active pattern 101 and each of the upper and lower surfaces of each of the first to third nanosheets NW1, NW2, and NW3. The second inner spacer material layer 122M may include or may be formed of a low dielectric constant material. For example, the second inner spacer material layer 122M may include or may be formed of a different material from the first inner spacer material layer 121M. For example, the second inner spacer material layer 122M may include or may be formed of any one of silicon nitride (SiN), silicon oxycarbide (SiOC), silicon oxynitride (SiON), silicon oxycarbonitride (SiOCN), and silicon carbonitride (SiCN).

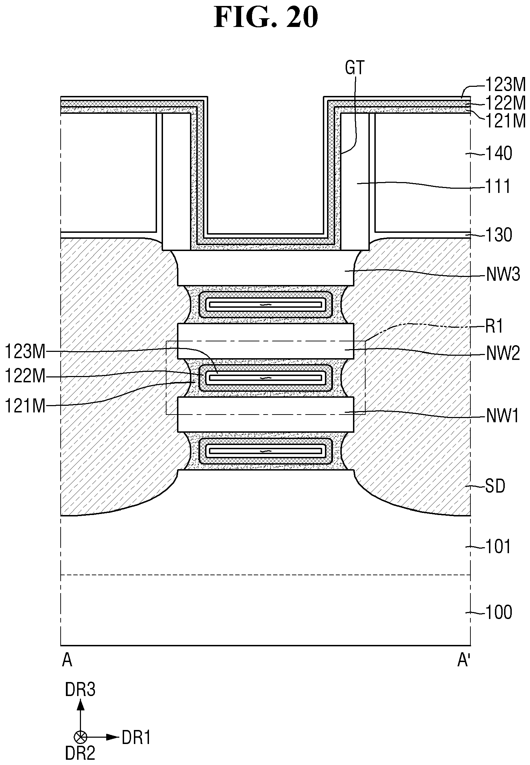

Referring to FIGS. 20 to 22, a third inner spacer material layer 123M may be conformally formed on the second inner spacer material layer 122M. The third inner spacer material layer 123M may be formed into a liner shape. For example, the third inner spacer material layer 123M may be formed on the second inner spacer material layer 122M inside the gate trench GT. For example, the third inner spacer material layer 123M may be formed on the second inner spacer material layer 122M on the upper surface of the gate spacer 111 and the upper surface of the first interlayer insulating layer 140.

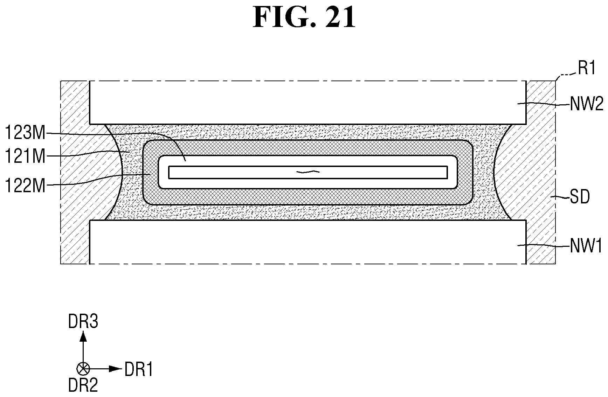

For example, as shown in FIGS. 20 and 21, in a cross section taken along the first horizontal direction DR1, the thickness in the first horizontal direction DR1 of the third inner spacer material layer 123M formed on the side wall of the source/drain region SD may be greater than the thickness in the vertical direction DR3 of the third inner spacer material layer 123M formed on the upper surface of the active pattern 101 and each of the upper surface and lower surface of each of the first to third nanosheets NW1, NW2, and NW3. The third inner spacer material layer 123M may include a low dielectric constant material. For example, the third inner spacer material layer 123M may include silicon oxide (SiO₂).

Although FIGS. 20 to 22 show that the third inner spacer material layer 123M is formed on the second inner spacer material layer 122M, the present disclosure is not limited thereto. In some embodiments, formation of the third inner spacer material layer 123M may be omitted.

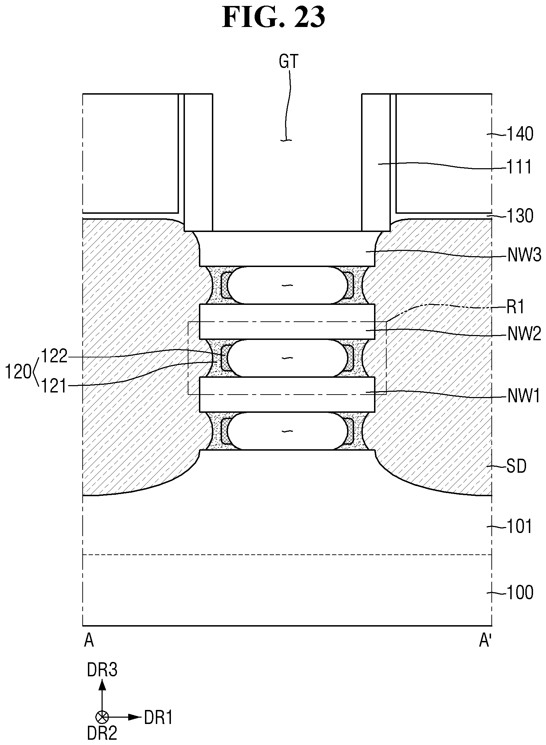

Referring to FIGS. 23 to 25, a wet etching process may be performed to etch a part of the first inner spacer material layer121M of FIGS. 20 to 22 and a part of the second inner spacer material layer 122M of FIGS. 20 to 22. In addition, when the third inner spacer material layer 123M of FIGS. 20 to 22 is formed in the process performed previously, the third inner spacer material layer 123M of FIGS. 20 to 22 may be etched entirely. After such an etching process is performed, the upper surface of the active pattern 101 and the upper and lower surfaces of each of the first to third nanosheets NW1, NW2, and NW3 may be exposed in a cross section taken along the first horizontal direction DR1. Furthermore, after performing such an etching process, the side wall and upper surface of the gate spacer 111 and the upper surface of the first interlayer insulating layer 140 may be exposed in a cross section taken along the first horizontal direction DR1. In addition, after performing such an etching process, in a cross section taken along the second horizontal direction DR2, the upper surface of the field insulating layer 105, the surface of the active pattern 101, and surfaces of each of the first to third nanosheets NW1, NW2, and NW3 may be exposed.

After such an etching process is performed, the first inner spacer material layer 121M of FIGS. 20 to 22 that remains on the side walls of the source/drain region SD between the active pattern 101 and each of the first to third nanosheets NW1, NW2, and NW3 may be defined as the first inner spacer 121. Furthermore, after such an etching process is performed, the second inner spacer material layer 122M of FIGS. 20 to 22 that remains on the side walls of the source/drain region SD between the active pattern 101 and each of the first to third nanosheets NW1, NW2, and NW3 may be defined as the second inner spacer 122. Therefore, the inner spacer 120 including the first inner spacer 121 and the second inner spacer 122 may be formed on the side wall of the source/drain region SD.

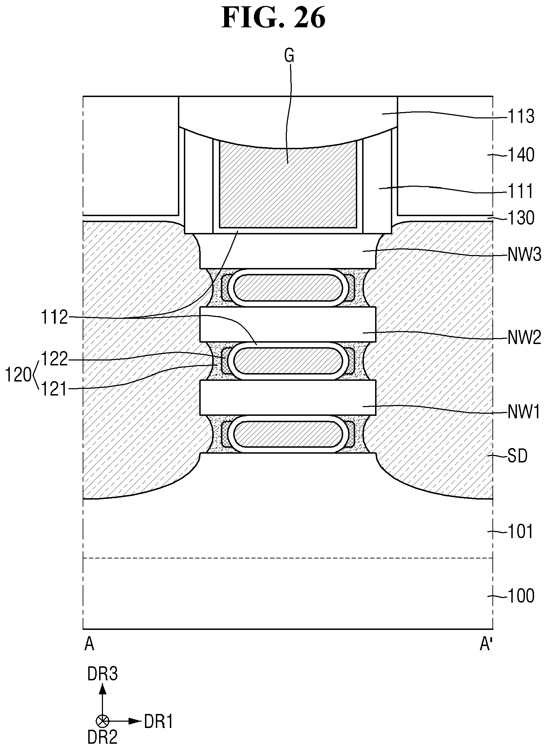

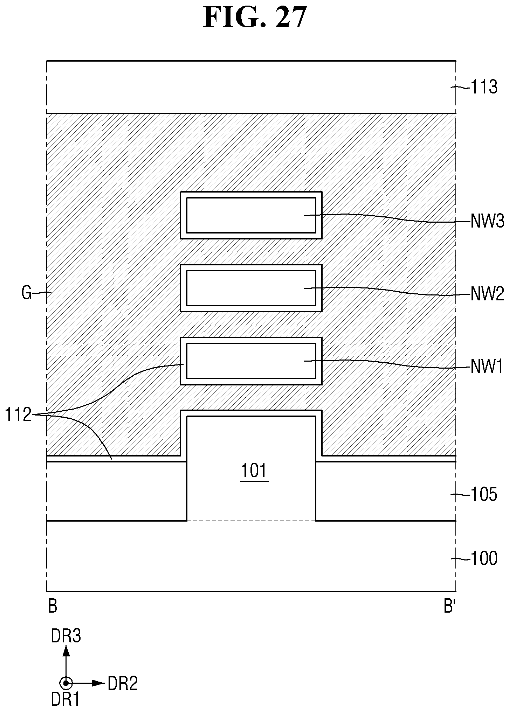

Referring to FIGS. 26 and 27, the gate insulating layer 112, the gate electrode G, and the capping pattern 113 may be sequentially formed inside the gate trench GT of FIG. 23. For example, the gate insulating layer 112 may be in contact with each of the side walls of the first inner spacer 121 and the second inner spacer 122.

Referring to FIGS. 2 to 4, the source/drain contact CA which penetrates the first interlayer insulating layer 140 in the vertical direction DR3 and is connected to the source/drain region SD may be formed. Furthermore, the silicide layer SL may be formed between the source/drain region SD and the source/drain contact CA. Further, the gate contact CB which penetrates the capping pattern 113 in the vertical direction DR3 and is connected to the gate electrode G may be formed. Subsequently, the second etching stop layer 150 and the second interlayer insulating layer 160 may be formed sequentially on the upper face of each of the first interlayer insulating layer 140, the capping pattern 113, the source/drain contact CA, and the gate contact CB.

Next, the first via V1 which penetrates the second etching stop layer 150 and the second interlayer insulating layer 160 in the vertical direction DR3 and is connected to the source/drain contact CA may be formed. Also, the second via V2 which penetrates the second etching stop layer 150 and the second interlayer insulating layer 160 in the vertical direction DR3 and is connected to the gate contact CB may be formed. The semiconductor device shown in FIGS. 2 to 4 may be fabricated through such a fabricating process.

When the inner spacer 120 is formed on the side wall of the sacrificial layer 11 before the source/drain region SD is formed, because the source/drain region SD is not epitaxially grown from the sacrificial layer 11, a problem occurred in the reliability of the source/drain region SD. In the semiconductor device according to some embodiments of the present disclosure, the inner spacer 120 may be formed on the side walls of the source/drain regions SD after the dummy gate DG is removed. That is, in the semiconductor device according to some embodiments of the present disclosure, after the source/drain region SD is formed, the inner spacer 120 may be formed on the side walls of the source/drain region SD.

In the semiconductor device according to some embodiments of the present disclosure, the inner spacer 120 may include the first inner spacer 121 and the second inner spacer 122 including different materials from each other. In the semiconductor device according to some embodiments of the disclosure, after the dummy gate DG is removed, the first inner spacer 121 and the second inner spacer 122 including different materials from each other may be formed on the side walls of the source/drain region SD. Accordingly, the thickness of the inner spacer 120 can be effectively adjusted to improve the reliability of the semiconductor device.

In the semiconductor device according to some embodiments of the present disclosure fabricated through the aforementioned fabricating method, the inner spacer 120 includes the first inner spacer 121 and the second inner spacer 122 including different materials from each other, and each of the upper and lower surfaces of the second inner spacer 122 that be in contact with the gate insulating layer 112 may be in contact with the first inner spacer 121 that is in contact with the source/drain region SD.

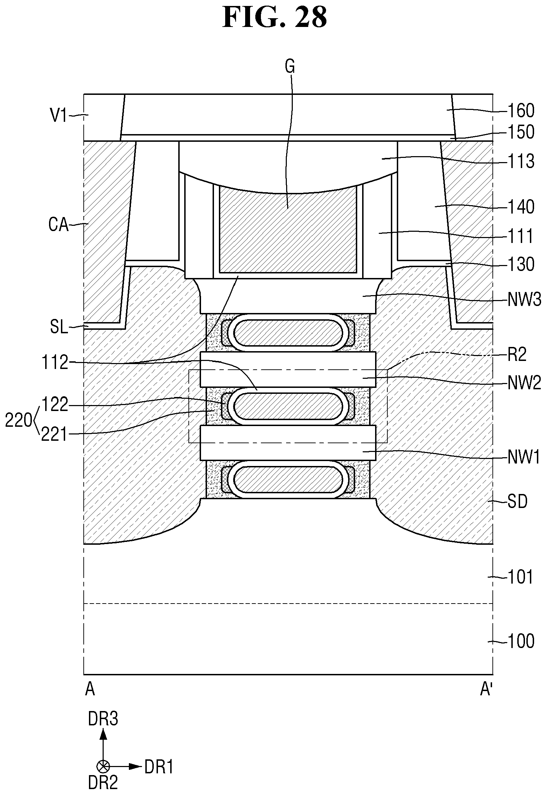

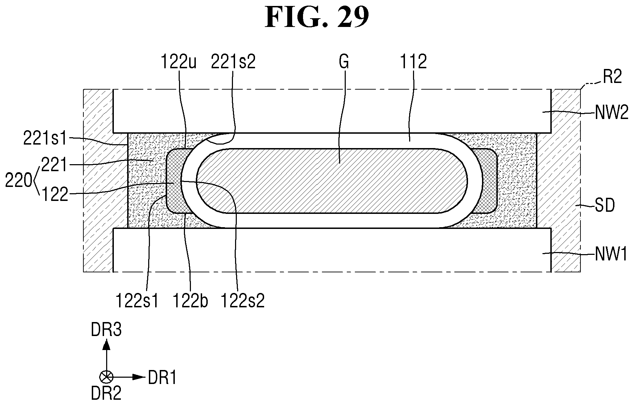

Hereinafter, a semiconductor device according to some embodiments of the present disclosure will be described with reference to FIGS. 28 and 29. The explanation will focus on the differences from the semiconductor device shown in FIGS. 1 to 4.

FIG. 28 is a cross-sectional view for explaining a semiconductor device according to some embodiments of the present disclosure. FIG. 29 is an enlarged view of a region R2 of FIG. 28.

Referring to FIGS. 28 and 29, in the semiconductor device according to some embodiments of the present disclosure, a side wall 221s1 of the first inner spacer 221 that is in contact with the source/drain region SD may extend along a straight line extending in the vertical direction DR3.

For example, the inner spacer 220 may include a first inner spacer 221 and a second inner spacer 122. The first inner spacer 221 may include a first side wall 221s1, and a second side wall 221s2 opposite to the first side wall 221s1 in the first horizontal direction DR1. The first side wall 221s1 of the first inner spacer 221 may be in contact with the source/drain region SD. The first side wall 221s1 of the first inner spacer 221 may extend along a straight line extending in the vertical direction DR3. The second side wall 221 s2 of the first inner spacer 221 may be in contact with the gate insulating layer 112.

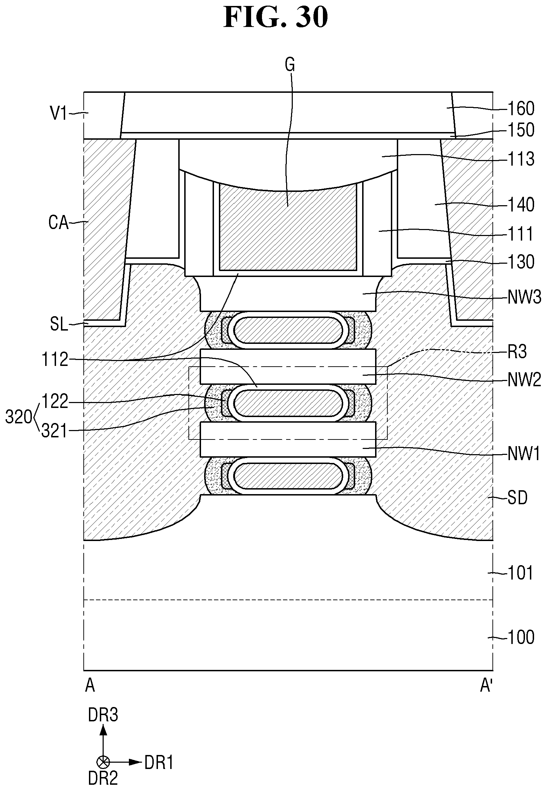

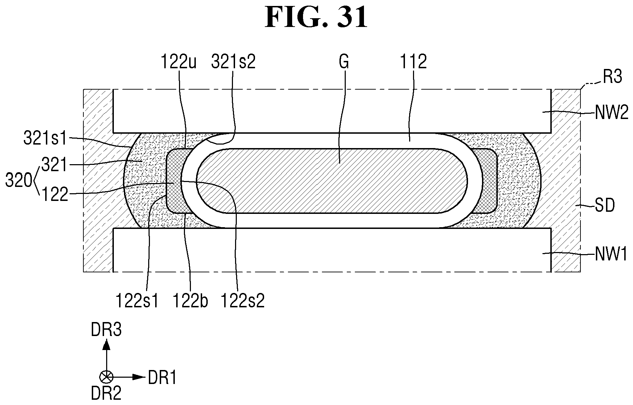

Hereinafter, the semiconductor device according to some embodiments of the present disclosure will be described with reference to FIGS. 30 and 31. The explanation will focus on the differences from the semiconductor devices shown in FIGS. 1 to 4.

FIG. 30 is a cross-sectional view for explaining a semiconductor device according to some embodiments of the present disclosure. FIG. 31 is an enlarged view of a region R3 of FIG. 30.

Referring to FIGS. 30 and 31, in the semiconductor device according to some embodiments of the present disclosure, a side wall 321s1 of a first inner spacer 321 that is in contact with the source/drain region SD may be formed into a convex shape toward the source/drain region SD (i.e., a portion of the source/drain region disposed in a space between two adjacent nanosheets of the plurality of nanosheets NW1, NW2, and NW3).

For example, the inner spacer 320 may include the first inner spacer 321 and a second inner spacer 122. The first inner spacer 321 may include a first side wall 321s1, and a second side wall 321s2 opposite to the first side wall 321s1 in the first horizontal direction DR1. The first side wall 321s1 of the first inner spacer 321 may be in contact with the source/drain region SD. The first side wall 321s1 of the first inner spacer 321 may be formed in a convex shape toward the source/drain region SD (i.e., a portion of the source/drain region disposed in a space between two adjacent nanosheets of the plurality of nanosheets NW1, NW2, and NW3). The second side wall 321s2 of the first inner spacer 321 may be in contact with the gate insulating layer 112.

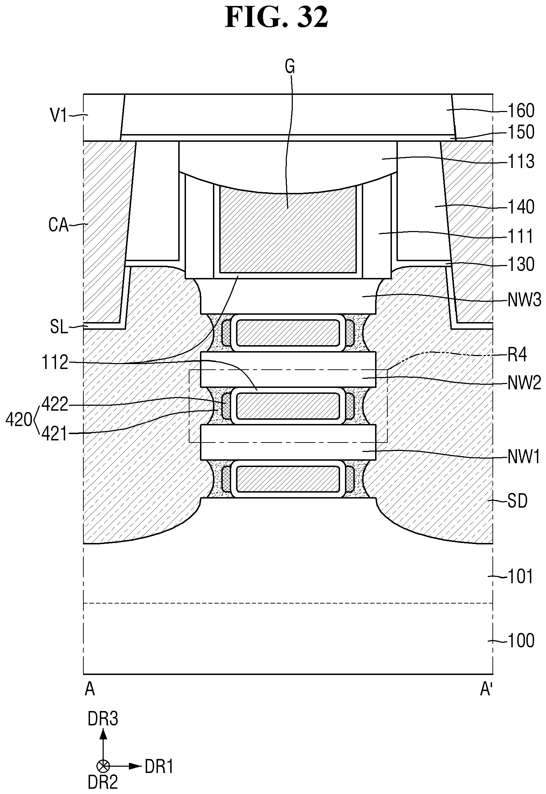

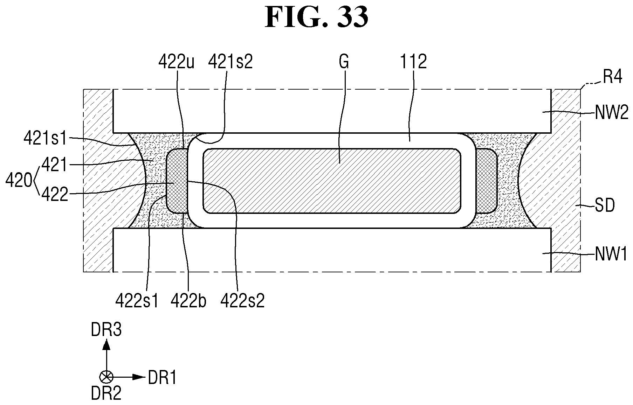

Hereinafter, a semiconductor device according to some embodiments of the present disclosure will be described with reference to FIGS. 32 and 33. The explanation will focus on the differences from the semiconductor device shown in FIGS. 1 to 4.

FIG. 32 is a cross-sectional view for explaining a semiconductor device according to some embodiments of the present disclosure. FIG. 33 is an enlarged view of a region R4 of FIG. 32.

Referring to FIGS. 32 and 33, in the semiconductor device according to some embodiments of the present disclosure, a side wall 422s2 of a second inner spacer 422 that is in contact with the gate insulating layer 112 may extend in the vertical direction DR3.

For example, the inner spacer 420 may include the first inner spacer 421 and a second inner spacer 422. The first inner spacer 421 may include a first side wall 421s1, and a second side wall 421s2 opposite to the first side wall 421s1 in the first horizontal direction DR1. The first side wall 421s1 of the first inner spacer 421 may be in contact with the source/drain region SD. The first side wall 421s1 of the first inner spacer 421 may be formed in a concave shape toward the gate electrode G. The second side wall 421s2 of the first inner spacer 421 may be in contact with the gate insulating layer 112.

For example, the second inner spacer 422 may include a first side wall 422s1, and a second side wall 422s2 opposite to the first side wall 422s1 in the first horizontal direction DR1. The first side wall 422s1 of the second inner spacer 422 may be in contact with the first inner spacer 421. The second side wall 422s2 of the second inner spacer 422 may be in contact with the gate insulating layer 112. The second side wall 422s2 of the second inner spacer 422 may extend in the vertical direction DR3. Each of the upper surface 422u and the lower surface 422b of the second inner spacer 422 may be in contact with the first inner spacer 421.

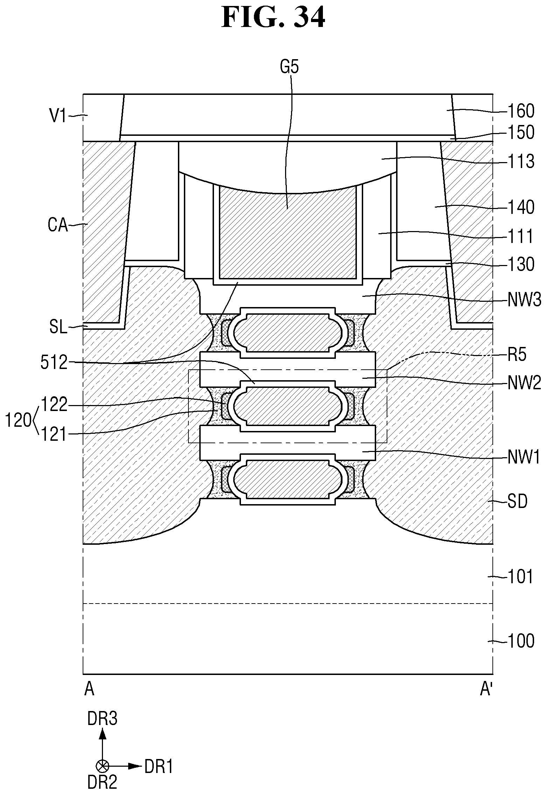

Hereinafter, a semiconductor device according to some embodiments of the present disclosure will be described with reference to FIGS. 34 to 36. The explanation will focus on the differences from the semiconductor devices as shown in FIGS. 1 to 4.

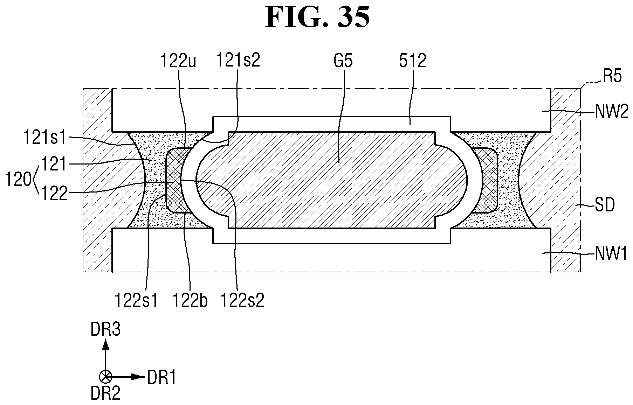

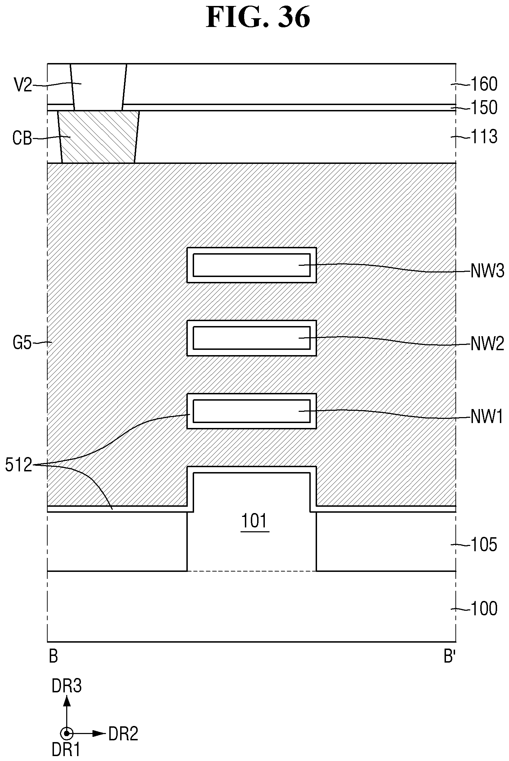

FIGS. 34 and 36 are cross-sectional views for explaining a semiconductor device according to some embodiments of the present disclosure. FIG. 35 is an enlarged view of a region R5 of FIG. 34.

Referring to FIGS. 34 to 36, in the semiconductor device according to some embodiments of the present disclosure, at least a part of a gate insulating layer 512 may overlap each of the plurality of nanosheets NW1, NW2, and NW3 in the first horizontal direction DR1 in a cross section taken in the first horizontal direction DR1.

For example, in the cross section taken in the first horizontal direction DR1, the gate electrode G5 may protrude in the vertical direction DR3 toward the upper and lower surfaces of each of the plurality of nanosheets NW1, NW2, and NW3. In the cross section taken in the first horizontal direction DR1, the gate electrode G5 may protrude toward the upper surface of the active pattern 101 in the vertical direction DR3.

For example, the gate insulating layer 512 may be disposed between the gate electrode G5 and each of the plurality of nanosheets NW1, NW2, and NW3. The surfaces of each of the plurality of nanosheets NW1, NW2, and NW3 that are in contact with the gate insulating layer 512 may be formed to be recessed in the vertical direction DR3 toward the center of each of the plurality of nanosheets NW1, NW2, and NW3. The gate insulating layer 512 may be in contact with the surfaces of each of the plurality of nanosheets NW1, NW2, and NW3 formed to be recessed in the vertical direction DR3 toward the center of each of the plurality of nanosheets NW1, NW2, and NW3. For example, the gate insulating layer 512 may contact recessed upper and lower surfaces of each nanosheet of the plurality of nanosheets NW1, NW2, and NW3. Accordingly, in a cross section taken in the first horizontal direction DR1, at least a part of the gate insulating layer 512 may overlap each of the plurality of nanosheets NW1, NW2, and NW3 in the first horizontal direction DR1.

Furthermore, the gate insulating layer 512 may be disposed between the gate electrode G5 and the active pattern 101. The upper surface of the active pattern 101 that is in contact with the gate insulating layer 512 may be formed to be recessed toward the substrate 100 in the vertical direction DR3. The gate insulating layer 512 may be in contact with the upper surface of the active pattern 101 formed to be recessed toward the substrate 100 in the vertical direction DR3. For example, the gate insulating layer 512 may contact a recessed upper surface of the active pattern 101. Accordingly, in the cross section taken in the first horizontal direction DR1, at least a part of the gate insulating layer 512 may overlap the active pattern 101 in the first horizontal direction DR1.

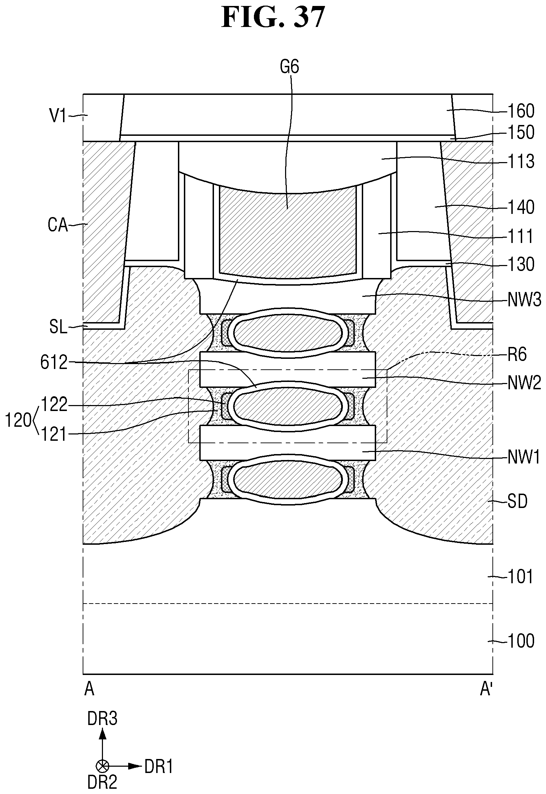

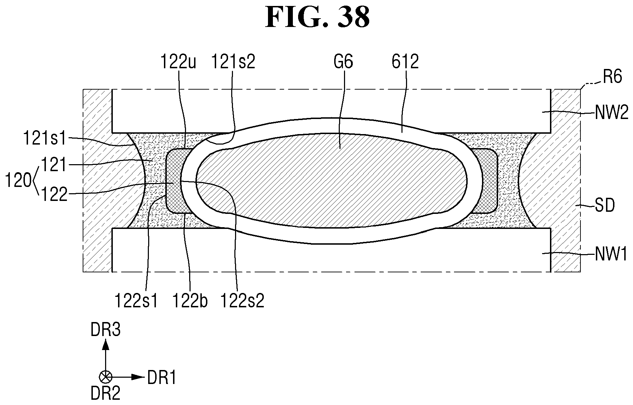

Hereinafter, a semiconductor device according to some embodiments of the present disclosure will be described with reference to FIGS. 37 and 38. The explanation will focus on the differences from the semiconductor device shown in FIGS. 1 to 4.

FIG. 37 is a cross-sectional view for explaining the semiconductor device according to some embodiments of the present disclosure. FIG. 38 is an enlarged view of a region R6 of FIG. 37.

Referring to FIGS. 37 and 38, in the semiconductor device according to some embodiments of the present disclosure, at least a part of a gate insulating layer 612 may overlap each of the plurality of nanosheets NW1, NW2, and NW3 in the first horizontal direction DR1, in a cross section taken in the first horizontal direction DR1.

For example, in the cross section taken in the first horizontal direction DR1, a gate electrode G6 may protrude toward the upper and lower surfaces of each of the plurality of nanosheets NW1, NW2, and NW3 in the vertical direction DR3. In the cross section taken in the first horizontal direction DR1, the surface of the gate electrode G6 that faces the upper and lower surfaces of each of the plurality of nanosheets NW1, NW2, and NW3 may have a curved shape. Further, in the cross section taken in the first horizontal direction DR1, the gate electrode G5 may protrude toward the upper surface of the active pattern 101 in the vertical direction DR3. In the cross section taken in the first horizontal direction DR1, the surface of the gate electrode G6 that faces the upper surface of the active pattern 101 may have a curved shape.

For example, the gate insulating layer 612 may be disposed between the gate electrode G6 and each of the plurality of nanosheets NW1, NW2, and NW3. The surfaces of each of the plurality of nanosheets NW1, NW2, and NW3 that be in contact with the gate insulating layer 612 may be formed to be recessed toward the center of each of the plurality of nanosheets NW1, NW2, and NW3 in the vertical direction DR3. In the cross section taken in the first horizontal direction DR1, the surfaces of each of the plurality of nanosheets NW1, NW2, and NW3 that be in contact with the gate insulating layer 612 may be recessed in the vertical direction DR3 to have a curved shape. The gate insulating layer 612 may be in contact with the surfaces of each of the plurality of nanosheets NW1, NW2, and NW3 formed to be recessed toward the center of each of the plurality of nanosheets NW1, NW2, and NW3 in the vertical direction DR3. For example, the gate insulating layer 612 may contact recessed upper and lower surfaces of each of the plurality of nanosheets NW1, NW2, and NW3. Unlike the embodiments of FIGS. 34 and 35 in which the recessed upper and lower surfaces of each of the nanosheets NW1, NW2, and NW3 are flat, the recessed upper and lower surfaces of each of the nanosheets NW1, NW2, and NW3 in FIGS. 37 and 38 may be curved. Accordingly, in the cross section taken in the first horizontal direction DR1, at least a part of the gate insulating layer 612 may overlap each of the plurality of nanosheets NW1, NW2, and NW3 in the first horizontal direction DR1.

Furthermore, the gate insulating layer 612 may be disposed between the gate electrode G6 and the active pattern 101. The upper surface of the active pattern 101 that is in contact with the gate insulating layer 612 may be formed to be recessed toward the substrate 100 in the vertical direction DR3. In the cross section taken in the first horizontal direction DR1, the upper surface of the active pattern 101 that is in contact with the gate insulating layer 612 may be recessed in the vertical direction DR3 to have a curved shape. The gate insulating layer 612 may be in contact with the upper surface of the active pattern 101 formed to be recessed toward the substrate 100 in the vertical direction DR3. For example, the gate insulating layer 612 may contact a recessed upper surface of the active pattern 101. Unlike the embodiments of FIGS. 34 and 35 in which the recessed upper surface of the active pattern 101 is flat, the recessed upper surface of FIGS. 37 and 38 may be curved. Accordingly, in the cross section taken in the first horizontal direction DR1, at least a part of the gate insulating layer 612 may overlap the active pattern 101 in the first horizontal direction DR1.

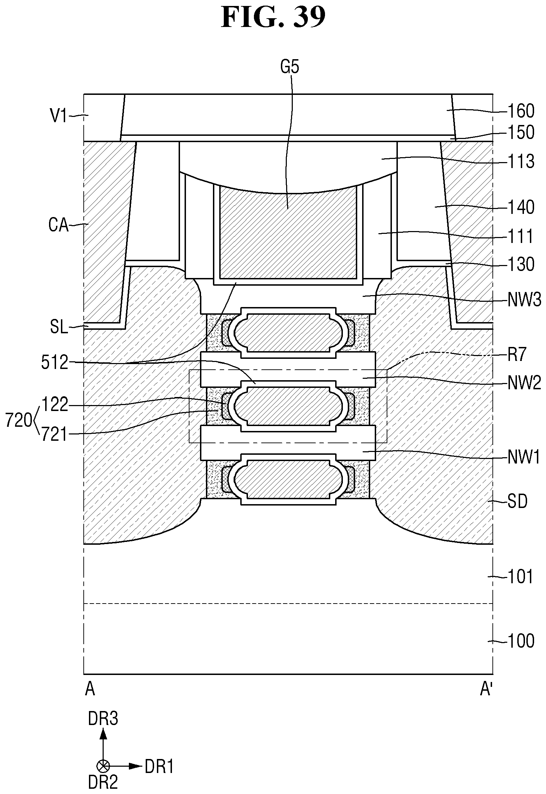

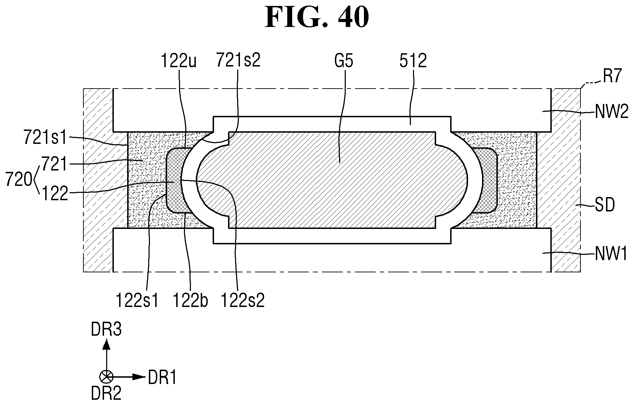

Hereinafter, a semiconductor device according to some embodiments of the present disclosure will be described with reference to FIGS. 39 and 40. The explanation will focus on the differences from the semiconductor device as shown in FIGS. 34 to 36.

FIG. 39 is a cross-sectional view for explaining a semiconductor device according to some embodiments of the present disclosure. FIG. 40 is an enlarged view of a region R7 of FIG. 39.

Referring to FIGS. 39 and 40, in the semiconductor device according to some embodiments of the present disclosure, in a cross section taken in the first horizontal direction DR1, at least a part of the gate insulating layer 512 may overlap each of the plurality of nanosheets NW1, NW2 and NW3 in the first horizontal direction DR1. Further, a side wall 721s1 of a first inner spacer 721 that is in contact with the source/drain region SD may extend in the vertical direction DR3. For example, the side wall 721s1 may be a flat surface extending in the vertical direction DR3.

For example, an inner spacer 720 may include the first inner spacer 721 and a second inner spacer 122. The first inner spacer 721 may include a first side wall 721s1, and a second side wall 721s2 opposite to the first side wall 721s1 in the first horizontal direction DR1. The first side wall 721s1 of the first inner spacer 721 may be in contact with the source/drain region SD. The first side wall 721s1 of the first inner spacer 721 may extend in the vertical direction DR3. The first side wall 721s1 may be a flat surface extending in the vertical direction DR3. The second side wall 721s2 of the first inner spacer 721 may be in contact with the gate insulating layer 512.

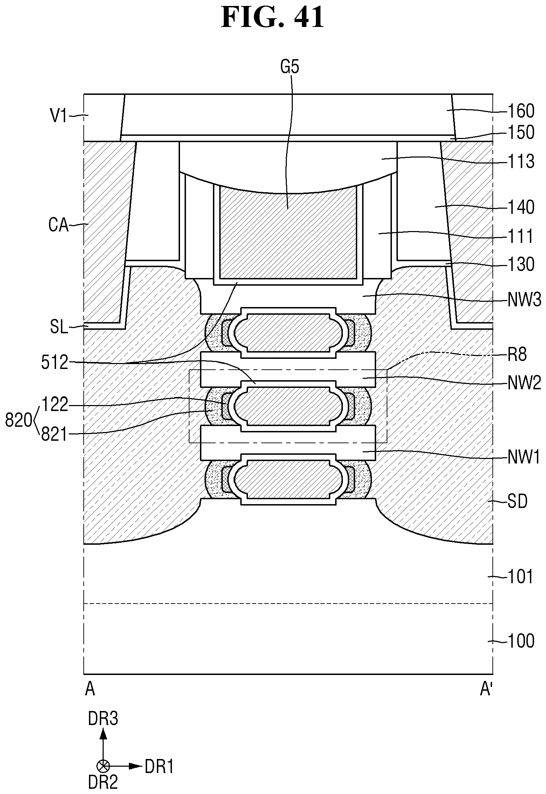

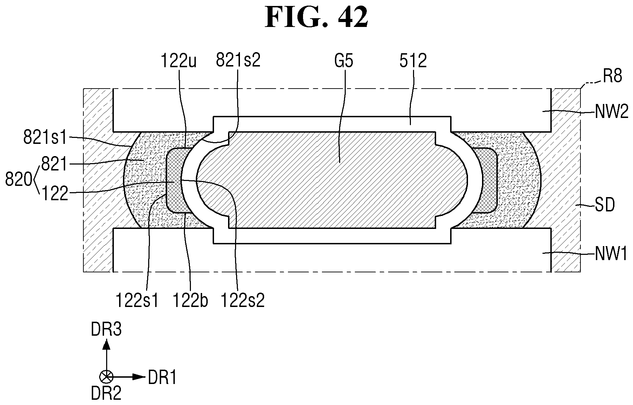

Hereinafter, a semiconductor device according to some embodiments of the present disclosure will be described with reference to FIGS. 41 and 42. The explanation will focus on the differences from the semiconductor device as shown in FIGS. 34 to 36.

FIG. 41 is a cross-sectional view for explaining a semiconductor device according to some embodiments of the present disclosure. FIG. 42 is an enlarged view of a region R8 of FIG. 41.

Referring to FIGS. 41 and 42, in the semiconductor device according to some embodiments of the present disclosure, in a cross section taken in the first horizontal direction DR1, at least a part of the gate insulating layer 512 may overlap each of the plurality of nanosheets NW1, NW2 and NW3 in the first horizontal direction DR1. Furthermore, a side wall 821s1 of a first inner spacer 821 that is in contact with the source/drain region SD may be formed in a convex shape toward the source/drain region SD.

For example, an inner spacer 820 may include the first inner spacer 821 and a second inner spacer 122. The first inner spacer 821 may include a first side wall 821s1, and a second side wall 821s2 opposite to the first side wall 821s1 in the first horizontal direction DR1. The first side wall 821s1 of the first inner spacer 821 may be in contact with the source/drain region SD. The first side wall 821s1 of the first inner spacer 821 may be formed in a convex shape toward the source/drain region SD. The second side wall 821s2 of the first inner spacer 821 may be in contact with the gate insulating layer 512.

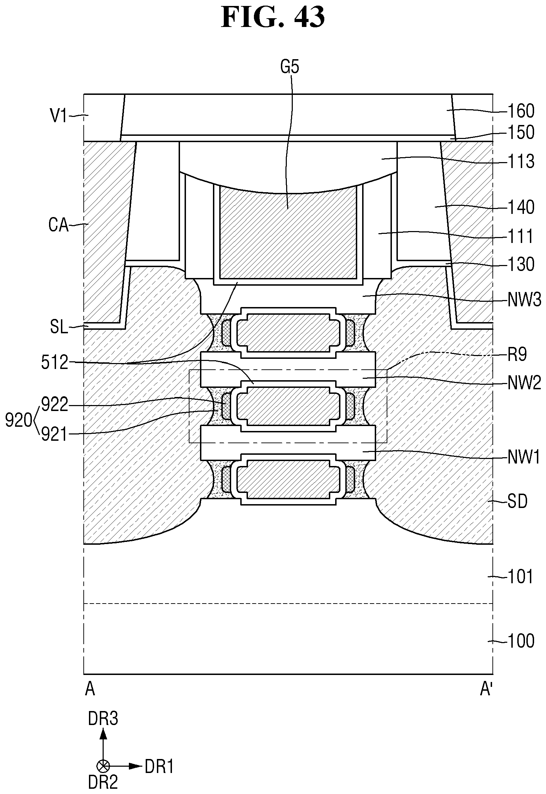

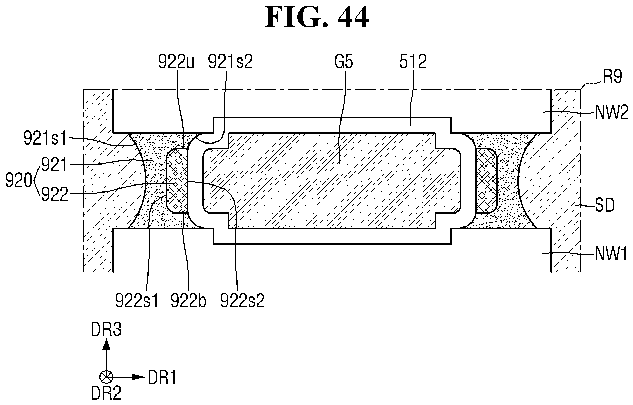

Hereinafter, a semiconductor device according to some embodiments of the present disclosure will be described with reference to FIGS. 43 and 44. The explanation will focus on the differences from the semiconductor device shown in FIGS. 34 to 36.

FIG. 43 is a cross-sectional view for explaining a semiconductor device according to some embodiments of the present disclosure. FIG. 44 is an enlarged view of a region R9 of FIG. 43.

Referring to FIGS. 43 and 44, in the semiconductor device according to some embodiments of the present disclosure, in a cross section taken in the first horizontal direction DR1, at least a part of the gate insulating layer 512 may overlap each of the plurality of nanosheets NW1, NW2, and NW3 in the first horizontal direction DR1. A side wall 922s2 of a second inner spacer 922 that is in contact with the gate insulating layer 512 may extend in the vertical direction DR3.

For example, the inner spacer 920 may include a first inner spacer 921 and the second inner spacer 922. The first inner spacer 921 may include a first side wall 921s1, and a second side wall 921s2 opposite to the first side wall 921s1 in the first horizontal direction DR1. The first side wall 921s1 of the first inner spacer 921 may be in contact with the source/drain region SD. The first side wall 921s1 of the first inner spacer 921 may be formed in a concave shape toward the gate electrode G5. The second side wall 921s2 of the first inner spacer 921 may be in contact with the gate insulating layer 512.

For example, the second inner spacer 922 may include a first side wall 922s1, and a second side wall 922s2 opposite to the first side wall 922s 1 in the first horizontal direction DR1. The first side wall 922s1 of the second inner spacer 922 may be in contact with the first inner spacer 921. The second side wall 922s2 of the second inner spacer 922 may be in contact with the gate insulating layer 512. The second side wall 922s2 of the second inner spacer 922 may extend in the vertical direction DR3. Each of an upper surface 922u and a lower surface 922b of the second inner spacer 922 may be in contact with the first inner spacer 921.

Although the embodiments of the present disclosure have been described above with reference to the accompanying drawings, the present disclosure is not limited to the above embodiments, and may be fabricated in various different forms. Those skilled in the art will appreciate that the present disclosure may be embodied in other specific forms without changing the essential features of the present disclosure. Accordingly, the above-described embodiments should be understood in all respects as illustrative and not restrictive.

Embodiments of the invention may also be defined by the following clauses.

Clause 1. A semiconductor device comprising:
a substrate;
an active pattern extending in a first horizontal direction on the substrate;
a plurality of nanosheets stacked to be spaced apart from each other in a vertical direction on the active pattern;
a gate electrode extending in a second horizontal direction different from the first horizontal direction on the active pattern, the gate electrode surrounding the plurality of nanosheets;
a source/drain region disposed on at least one side of the gate electrode on the active pattern;
a first inner spacer disposed between the source/drain region and the gate electrode between the plurality of nanosheets, the first inner spacer being in contact with the source/drain region; and
a second inner spacer disposed between the first inner spacer and the gate electrode between the plurality of nanosheets, the second inner spacer including a material different from a material of the first inner spacer, each of an uppermost surface and a lowermost surface of the second inner spacer being in contact with the first inner spacer.

Clause 2. The semiconductor device of clause 1,
wherein the second inner spacer is spaced apart from each of the plurality of nanosheets in the vertical direction.

Clause 3. The semiconductor device of clause 1 or 2,
wherein the second inner spacer is spaced apart from the source/drain region in the first horizontal direction.

Clause 4. The semiconductor device of any preceding clause, further comprising
a gate insulating layer disposed between each of the plurality of nanosheets, the first inner spacer and the second inner spacer and the gate electrode, the gate insulating layer being in contact with each of the plurality of nanosheets, the first inner spacer and the second inner spacer.

Clause 5. The semiconductor device of clause 4,
wherein in a cross section taken along the first horizontal direction, at least a part of the gate insulating layer overlaps each of the plurality of nanosheets in the first horizontal direction.

Clause 6. The semiconductor device of clause 4 or 5,
wherein a side wall of the second inner spacer being in contact with the gate insulating layer is formed in a concave shape toward the source/drain region.

Clause 7. The semiconductor device of any preceding clause,
wherein a side wall of the source/drain region being in contact with the first inner spacer is formed to be closer to the gate electrode than side walls in the first horizontal direction of each of the plurality of nanosheets.

Clause 8. The semiconductor device of any preceding clause,
wherein at least a part of the first inner spacer between the plurality of nanosheets overlaps the gate electrode in the vertical direction.

Clause 9. The semiconductor device of any preceding clause 1,
wherein a side wall of the first inner spacer being in contact with the source/drain region is formed in a concave shape toward the gate electrode.

Clause 10. The semiconductor device of any one of clauses 1 to 8,
wherein a side wall of the first inner spacer being in contact with the source/drain region is formed in a convex shape toward the source/drain region.

Clause 11. A semiconductor device comprising:
a substrate;
an active pattern extending in a first horizontal direction on the substrate;
a plurality of nanosheets stacked to be spaced apart from each other in a vertical direction on the active pattern;
a gate electrode extending in a second horizontal direction different from the first horizontal direction on the active pattern, the gate electrode surrounding the plurality of nanosheets;
a gate insulating layer disposed between the plurality of nanosheets and the gate electrode;
a source/drain region disposed on at least one side of the gate electrode on the active pattern;
a first inner spacer disposed between the source/drain region and the gate insulating layer between the plurality of nanosheets, the first inner spacer including a first side wall being in contact with the source/drain region, and a second side wall being in contact with the gate insulating layer; and
a second inner spacer disposed between the first inner spacer and the gate insulating layer between the plurality of nanosheets, the second inner spacer including a material different from a material of the first inner spacer, the second inner spacer including a first side wall being in contact with the first inner spacer, and a second side wall being in contact with the gate insulating layer, the second inner spacer spaced apart from each of the plurality of nanosheets in the vertical direction.

Clause 12. The semiconductor device of clause 11,
wherein the first side wall of the first inner spacer is formed in a concave shape toward the gate electrode.

Clause 13. The semiconductor device of clause 11 or 12,
wherein the first side wall of the first inner spacer extends in the vertical direction.

Clause 14. The semiconductor device of clause 11, 12 or 13,
wherein the second side wall of the second inner spacer is formed in a concave shape toward the source/drain region.

Clause 15. The semiconductor device of any one of clauses 11 to 14,
wherein the second side wall of the second inner spacer extends in the vertical direction.

Clause 16. The semiconductor device of any preceding clause, wherein the gate insulating layer, or a gate insulating layer, is disposed between at least one of the plurality of nanosheets and the gate electrode, the gate insulating layer being in contact with said at least one of the plurality of nanosheets, the first inner spacer and the second inner spacer.

## Claims

1. A semiconductor device comprising:
a substrate provided with an active pattern extending in a first horizontal direction parallel to an upper surface of the substrate;
a plurality of nanosheets disposed on the active pattern and stacked to be spaced apart from each other in a vertical direction perpendicular to the upper surface of the substrate;
a gate electrode disposed on the active pattern and extending in a second horizontal direction parallel to the upper surface of the substrate and different from the first horizontal direction, the gate electrode surrounding each of the plurality of nanosheets;
a source/drain region disposed on the active pattern and disposed on a first side of the gate electrode;
a first inner spacer disposed between the source/drain region and a first portion of the gate electrode disposed in a space between two adjacent nanosheets of the plurality of nanosheets, the first inner spacer contacting the source/drain region, and the first portion of the gate electrode being lower than an upper surface of the source/drain region; and
a second inner spacer disposed between the first inner spacer and the first portion of the gate electrode, the second inner spacer including a material different from a material of the first inner spacer, and each of an upper surface and a lower surface of the second inner spacer contacting the first inner spacer.

2. The semiconductor device of claim 1,
wherein the second inner spacer is spaced apart from each of the plurality of nanosheets in the vertical direction.

3. The semiconductor device of claim 1 or 2,
wherein the second inner spacer is spaced apart from the source/drain region in the first horizontal direction.

4. The semiconductor device of any preceding claim further comprising
a gate insulating layer disposed in a space between an upper nanosheet of the two adjacent nanosheets and the first portion of the gate electrode, a space between a lower nanosheet of the two adjacent nanosheets and the first portion of the gate electrode, and a space between the second inner spacer and the first portion of the gate electrode, and
wherein the gate insulating layer contacts the two adjacent nanosheets, the first portion of the gate electrode, the first inner spacer, and the second inner spacer.

5. The semiconductor device of claim 4,
wherein in a cross section taken along the first horizontal direction, at least a part of the gate insulating layer overlaps each of the two adjacent nanosheets of the plurality of nanosheets in the first horizontal direction.

6. The semiconductor device of claim 4 or 5,
wherein in a cross section taken along the first horizontal direction, a side wall of the second inner spacer contacting the gate insulating layer is formed in a concave shape toward a portion of the source/drain region, and wherein the portion of the source/drain region contacts the first inner spacer and is disposed in the space between the two adjacent nanosheets of the plurality of nanosheets.

7. The semiconductor device of any preceding claim,
wherein a side wall of the source/drain region contacting the first inner spacer is closer to the first portion of the gate electrode than side walls of the two adjacent nanosheets in the first horizontal direction, and
wherein the side walls of the two adjacent nanosheets are adjacent to the first side of the gate electrode in the first horizontal direction.

8. The semiconductor device of any preceding claim,
wherein at least a part of the first inner spacer between the plurality of nanosheets overlaps the first portion of the gate electrode in the vertical direction.

9. The semiconductor device of any preceding claim,
wherein a side wall of the first inner spacer contacting the source/drain region is formed in a concave shape toward the first portion of the gate electrode.

10. The semiconductor device of any one of claims 1 to 8,
wherein a side wall of the first inner spacer contacting a portion of the source/drain region is formed in a convex shape toward the portion of the source/drain region, and
wherein the portion of the source/drain region is disposed in the space between the two adjacent nanosheets of the plurality of nanosheets.

11. A semiconductor device comprising:
a substrate provided with an active pattern extending in a first horizontal direction parallel to an upper surface of the substrate;
a plurality of nanosheets disposed on the active pattern and stacked to be spaced apart from each other in a vertical direction perpendicular to the upper surface of the substrate;
a gate electrode disposed on the active pattern and extending in a second horizontal direction parallel to the upper surface of the substrate and different from the first horizontal direction, the gate electrode surrounding each of the plurality of nanosheets;
a gate insulating layer disposed between a first portion of the gate electrode and each of two adjacent nanosheets of the plurality of nanosheets, wherein the first portion of the gate electrode is lower than the upper surface of the substrate;
a source/drain region disposed on the active pattern and disposed on a first side of the gate electrode;
a first inner spacer disposed in a space between the source/drain region and the gate insulating layer between the two adjacent nanosheets of the plurality of nanosheets, the first inner spacer including a first side wall contacting the source/drain region, and a second side wall contacting the gate insulating layer; and
a second inner spacer disposed in a space between the first inner spacer and the gate insulating layer between the two adjacent nanosheets of the plurality of nanosheets, the second inner spacer including a material different from a material of the first inner spacer, the second inner spacer including a first side wall contacting the first inner spacer and a second side wall contacting the gate insulating layer, and the second inner spacer spaced apart from each of the plurality of nanosheets in the vertical direction.

12. The semiconductor device of claim 11,
wherein the first side wall of the first inner spacer is formed in a concave shape toward the gate electrode.

13. The semiconductor device of claim 11 or 12,
wherein the first side wall of the first inner spacer extends along a straight line extending in the vertical direction.

14. The semiconductor device of claim 11, 12 or 13,
wherein the second side wall of the second inner spacer is formed in a concave shape toward the source/drain region.

15. The semiconductor device of any one of claims 11 to 14,
wherein the second side wall of the second inner spacer extends in the vertical direction.
